# EUROPEAN PATENT SPECIFICATION

(11) **EP 4 276 449 B1**
(45) Date of publication and mention of the grant of the patent: **10.12.2025**
(21) Application number: 22920745.1
(22) Date of filing: 27.07.2022
(51) Int. Cl.: G09B 19/24, G09B 5/02, G01N 21/88, G01N 21/956, G06T 7/00, G06F 30/20, H01M 10/42, G01N 21/17

(54) **VISION INSPECTOR SIMULATION DEVICE AND METHOD FOR SECONDARY BATTERY PRODUCTION**
SICHTPRÜFSIMULATORSIMULATIONSVORRICHTUNG UND VERFAHREN ZUR SEKUNDÄRBATTERIEHERSTELLUNG
DISPOSITIF DE SIMULATION D'INSPECTEUR DE VISION ET PROCÉDÉ DE PRODUCTION DE BATTERIES SECONDAIRES

(30) Priority: 11.01.2022 KR 20220004167
(43) Date of publication of application: 15.11.2023
(73) Proprietor: LG Energy Solution, Ltd., Seoul 07335 (KR)
(72) Inventor: JO, Gyeong Yun, Daejeon 34122 (KR); HONG, Young Hun, Daejeon 34122 (KR); KIM, Youngduk, Daejeon 34122 (KR); KIM, Nam Hyuck, Daejeon 34122 (KR); JEON, Su Ho, Daejeon 34122 (KR); KIM, Jaekyeong, Cheonan-si, Chungcheongnam-do 31118 (KR)
(74) Representative: BCKIP Part mbB
(86) International application number: PCT/KR2022/011086
(87) International publication number: WO 2023/136412

(56) References cited:
- CA-A1- 3 103 277
- KR-A- 20190 128 111
- KR-A- 20200 103 150
- KR-B1- 101 167 096
- KR-B1- 101 675 348
- US-A1- 2017 108 551
- US-A1- 2021 043 011

## Description

### TECHNICAL FIELD

The present invention specifically relates to a simulation apparatus and method for secondary battery production as well as a computer program and the present disclosure more generally relates to a vision inspector simulation apparatus and method of training secondary battery production workers.

### BACKGROUND ART

Due to the recent growth of the electric vehicle market, the demand for developing and producing secondary batteries is rapidly increasing. The number of production plants for secondary battery production is also growing in response to the increase in demand for secondary batteries. However, the industry is experiencing a significant shortage of skilled workers for operating secondary battery production plants.

Meanwhile, in the past, training and education of new workers were carried out in such a way of learning a skill by watching experienced workers, but it became difficult to train and educate new workers for a long time due to the busy production schedule of secondary batteries. In addition, it is difficult to find a sufficient number of skilled workers due to the frequent resignation of workers. In addition, even if a worker is trained in a general method of operating a factory, it is not easy for the worker to immediately respond to various defect situations that may occur during factory operation.

US 2021/043011 A1 discloses an immersive ecosystem comprising a VR headset configured to display a 3D rendering to a user and sensor(s) configured to measure a user response to dynamic 3D asset(s) in the 3D rendering. The immersive ecosystem further comprises a processor, an AI engine, and a first non-transitory computer-readable storage medium encoded with program code executable for providing the 3D rendering to the VR headset. The AI engine is operably coupled to a second non-transitory computer-readable storage medium configured to store predetermined response values and time values for dynamic 3D assets. The AI engine comprises a third non-transitory computer-readable storage medium encoded with program code executable for receiving the measured user response, comparing the received user response to the predetermined response value at the predetermined time value, based on the comparison, modifying dynamic 3D asset(s), and communicating the modified dynamic 3D asset(s) to the processor for providing within 3D rendering.

CA 3103277 A1 discloses a virtual reality training and evaluation system comprising a visual display device, one or more user input devices, one or more computer processors, a memory, and a network communication device. Computer-executable instructions are stored in the memory and configured to cause the one or more computer processors to execute a virtual reality training program that simulates a virtual environment displayed on the visual display device. A user is typically prompted to complete a task within the virtual environment. The task may be an electrical, gas, or water construction, maintenance, or service task. User interactions with the virtual environment in order to complete the task are received via the one or more user input devices. The user's performance of the task (and related subtasks) is typically monitored and compared to defined evaluation criteria. Thereafter, the user may be provided with an evaluation.

JP 2010-231792 A discloses a training system of a semiconductor manufacturing device, which efficiently implements training of a user for the semiconductor manufacturing device. A device training server is connected to a user terminal through a circuit. In the device training server, a program storage means stores a program for simulation on the semiconductor manufacturing device. A condition data reception means receives condition data on the simulation on the semiconductor manufacturing device received from the user by the user terminaland transmitted through the circuit. A program execution means executes the program stored in the program storage means based on the received condition data. A result data transmission means transmits result data of the simulation performed by the executed program, to the user terminal through the circuit.

KR 20180073116 A discloses an apparatus for generating virtual FINEX processes including a process design configuration manager for generating a plurality of experimental conditions from a FINEX process condition and generating a priority value for the plurality of experimental conditions by respectively proceeding virtual experiments for the test conditions; and a simulator configuration manager for generating a virtual FINEX process according to a selected experimental condition among the plurality of experimental conditions.

US 2015/032497 A1 discloses that in a conventional manufacturing line simulation, there are a number of input items, and therefore, time is required for input. In addition, depending on the objective of the simulation, there are also parameters for which input is not required, and therefore, there is the problem of reducing the number of inputs according to the library. There are provided a simulation library presentation unit which presents, to a user, a plurality of items of model libraries which are stored in a storage unit so as to receive specification of items of the model libraries from the user, a priority degree imparting unit which, with respect to the specified items of the model libraries, uses an input association table stored in the storage unit in order to calculate the priorities of the input items so as to present an input screen to the user on the basis of the calculated priorities, a simulation input receiving unit for receiving input of the input items on the user screen, and a duplicate data generation unit which, with respect to the duplicate items indicated in the input item association table, duplicates data that has been already received at the simulation input receiving unit.

CN 107103811 A discloses a virtual detection teaching platform with industrial ultrathin material production detection equipment and a use method thereof. The platform comprises a virtual simulation laboratory three-dimensional environment module, a virtual simulation laboratory entity detection device, a virtual simulation laboratory three-dimensional simulation detection device, a virtual detection data module and a virtual detection software program. A use method comprises getting access to content in the catalogue of a virtual detection simulation laboratory, getting access to content in the catalogue of an entity detection device display area, getting access to content in the catalogue of a virtual detection display area, getting access to content in the catalogue of a virtual software display area, and providing the guidance of eight experiments by using a website experimental handout.

WO 93/08552 A1 discloses an interactive training system for simulating industrial equipment and processes. The system can operate in both free play and procedural modes. The system includes a plurality of displays simulating views of the industrial equipment and processes. Graphics overlays are used to simulate the appearance of displays and manipulable controls on the equipment. The graphics overlays are manipulated by the user by means of touch-sensitive screens to simulate the operation of actual controls. Glass I/O software controls the touch screen input and display generation. Simulation software controls the commands which generate the simulated visual and audio outputs. A procedure monitor software specifies what presentations are to be made based on internally stored courseware.

### DESCRIPTION OF THE INVENTION

### TECHNICAL OBJECTIVES

The object of the present invention is to provide a simulation apparatus and method for secondary battery production, as well as a computer program stored in a computer-readable medium to improve the production of secondary batteries and reduce a loss due to the occurrence of defects. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "... aspect according to an example", "the disclosure describes", or "the disclosure" describe technical teaching which relates to the understanding of the invention or its embodiments, which, however, is not claimed as such.

### TECHNICAL MEANS

The present invention is implemented in various ways including an apparatus and method as well as a computer program stored in a computer-readable medium, or, although not claimed, a computer-readable medium storing the computer program.

A simulation apparatus for secondary battery production according to the invention includes: a memory configured to store at least one instruction; and at least one processor configured to execute the at least one instruction stored in the memory to perform operations. The operations include: executing an apparatus operating unit including a 3D vision inspector related to secondary battery production and surface quality information related to surface quality of a material inspected by the 3D vision inspector; executing a defect checking unit including defective area information of the material detected by the 3D vision inspector; executing a detection adjustment unit including a plurality of adjustment parameters for determining an operation of the 3D vision inspector; obtaining at least one of first user action information obtained through the apparatus operating unit, first user condition information obtained through the detection adjustment unit, or first model recipe setting information obtained through the quality checking unit; determining the operation of the 3D vision inspector based on at least one of the first user action information, the first user condition information or the first model recipe setting information; and executing an operation of inspecting a surface of the material based on the operation of the 3D vision inspector.

According to an embodiment of the present disclosure, the operations include: executing a 3D vision inspector training scenario based on an operating process of the 3D vision inspector; executing, according to the 3D vision inspector training scenario, at least one of displaying a user action guide on the apparatus operating unit, displaying a user condition guide on the detection adjustment unit, or displaying a model recipe setting guide on the defect checking unit; obtaining at least one of first user action information based on the display of the user action guide, first user condition information based on the display of the user condition guide, or first model recipe setting information based on the display of the model recipe setting guide; and changing at least one of the apparatus operating unit, the detection adjustment unit, or the defect checking unit based on at least one of the obtained first user action information, first user condition information, or first model recipe setting information.

According to an embodiment of the present disclosure, the 3D vision inspector training scenario includes at least one of a vision inspection preparation training scenario or a vision inspection adjustment training scenario.

According to an embodiment of the present disclosure, the vision inspection preparation training scenario includes at least one of an inspection specification checking step, a new model registration step, an inspection start step, or a detection history inquiry step.

According to an embodiment of the present disclosure, the vision inspection adjustment training scenario includes at least one of a surface inspection adjustment training or an overlay adjustment training, the surface inspection adjustment training includes at least one of an image simulation step, a coating portion average brightness adjustment step, a surface defect detection setting step, an uncoated portion-coated portion boundary value setting step, a manual inspection area setting step, or a manual mismatch area setting step, and the overlay adjustment training includes at least one of an image simulation step, an overlay defect detection setting step, a camera position adjustment step, or a roll cleaning mode step.

According to an embodiment of the present disclosure, the operations further include: determining one or more quality parameters for determining inspection quality of the 3D vision inspector; calculating a value corresponding to the one or more quality parameters based on the operation of the 3D vision inspector; and generating quality information related to the inspection quality of the 3D vision inspector based on the calculated value corresponding to the one or more quality parameters.

According to an embodiment of the present disclosure, the operations further include: determining a defect scenario among a plurality of defect scenarios related to the operation of the 3D vision inspector; and changing at least one of the operation of the 3D vision inspector, the inspection quality information related to the inspection quality of the 3D vision inspector, or the surface quality information related to the surface quality of the material based on the one or more defect scenarios.

According to an embodiment of the present disclosure, the defect scenario may include at least one of a surface inspection overdetection scenario, a surface inspection undetection scenario, an overlay abnormality scenario, or a hardware abnormality scenario.

According to an embodiment of the present disclosure, the operations further include: executing at least one defect scenario of the surface inspection overdetection scenario, the surface inspection undetection scenario, the overlay abnormality scenario, or the hardware abnormality scenario; obtaining at least one of second user action information of operating at least a partial area of the 3D vision inspector, second user condition information of changing an adjustment parameter of the detection adjustment unit, or second model recipe setting information of changing a model recipe setting value of the quality checking unit; correcting the operation of the 3D vision inspector based on at least one of the obtained second user action information, second user condition information, or second model recipe setting information; calculating a value corresponding to the one or more quality parameters related to the inspection quality of the corrected 3D vision inspector; and correcting the inspection quality information related to the inspection quality of the corrected 3D vision inspector based on the calculated value corresponding to the one or more quality parameters.

According to an embodiment of the present disclosure, the operations further include outputting guide information including information required to resolve the one or more defect scenarios.

A vision inspector simulation method for secondary battery production according to the invention, being executed by at least one processor, includes: executing an apparatus operating unit including a 3D vision inspector related to secondary battery production and surface quality information related to surface quality of a material inspected by the 3D vision inspector; executing a defect checking unit including defective area information of the material detected by the 3D vision inspector; executing a detection adjustment unit including a plurality of adjustment parameters for determining an operation of the 3D vision inspector; obtaining at least one of first user action information obtained through the apparatus operating unit, first user condition information obtained through the detection adjustment unit, or first model recipe setting information obtained through the quality checking unit; determining the operation of the 3D vision inspector based on at least one of the first user action information, the first user condition information or the first model recipe setting information; and executing an operation of inspecting a surface of the material based on the operation of the 3D vision inspector.

According to an embodiment of the present disclosure, the method further include: executing a 3D vision inspector training scenario based on an operating process of the 3D vision inspector; executing, according to the 3D vision inspector training scenario, at least one of displaying a user action guide on the apparatus operating unit, displaying a user condition guide on the detection adjustment unit, or displaying a model recipe setting guide on the defect checking unit; obtaining at least one of first user action information based on the display of the user action guide, first user condition information based on the display of the user condition guide, or first model recipe setting information based on the display of the model recipe setting guide; and changing at least one of the apparatus operating unit, the detection adjustment unit, or the defect checking unit based on at least one of the obtained first user action information, first user condition information, or first model recipe setting information.

According to an embodiment of the present disclosure, the 3D vision inspector training scenario may include at least one of a vision inspection preparation training scenario or a vision inspection adjustment training scenario.

According to an embodiment of the present disclosure, the vision inspection preparation training scenario may include at least one of an inspection specification checking step, a new model registration step, an inspection start step, or a detection history inquiry step.

According to a not claimed embodiment of the method of the invention, the vision inspection adjustment training scenario may include at least one of a surface inspection adjustment training or an overlay adjustment training, the surface inspection adjustment training includes at least one of an image simulation step, a coating portion average brightness adjustment step, a surface defect detection setting step, an uncoated portion-coated portion boundary value setting step, a manual inspection area setting step, or a manual mismatch area setting step, and the overlay adjustment training may include at least one of an image simulation step, an overlay defect detection setting step, a camera position adjustment step, or a roll cleaning mode step.

According to an embodiment of the present disclosure, the method may further include: determining one or more quality parameters for determining inspection quality of the 3D vision inspector; calculating a value corresponding to the one or more quality parameters based on the operation of the 3D vision inspector; and generating quality information related to the inspection quality of the 3D vision inspector based on the calculated value corresponding to the one or more quality parameters.

According to an embodiment of the present disclosure, the method may further include: determining a defect scenario among a plurality of defect scenarios related to the operation of the 3D vision inspector; and changing at least one of the operation of the 3D vision inspector, the inspection quality information related to the inspection quality of the 3D vision inspector, or the surface quality information related to the surface quality of the material based on the one or more defect scenarios.

According to a not claimed embodiment of the method of the invention, the defect scenario may include at least one of a surface inspection overdetection scenario, a surface inspection undetection scenario, an overlay abnormality scenario, or a hardware abnormality scenario.

According to a not claimed embodiment of the method of the invention, the method may further include: executing at least one defect scenario of the surface inspection overdetection scenario, the surface inspection undetection scenario, the overlay abnormality scenario, or the hardware abnormality scenario; obtaining at least one of second user action information of operating at least a partial area of the 3D vision inspector, second user condition information of changing an adjustment parameter of the detection adjustment unit, or second model recipe setting information of changing a model recipe setting value of the quality checking unit; correcting the operation of the 3D vision inspector based on at least one of the obtained second user action information, second user condition information or second model recipe setting information; calculating a value corresponding to the one or more quality parameters related to the inspection quality of the corrected 3D vision inspector; and correcting the inspection quality information related to the inspection quality of the corrected 3D vision inspector based on the calculated value corresponding to the one or more quality parameters.

According to a not claimed embodiment of the method of the invention, the method may further include outputting guide information including information required to resolve the one or more defect scenarios.

The invention also provides a computer program stored in a computer-readable medium is provided to execute the method according to an embodiment of the present disclosure on a computer.

### EFFECTS OF THE INVENTION

In various embodiments of the present disclosure, a user performing secondary battery production may perform training related to a method of operating a vision inspector for secondary battery production, a method of condition adjustment, and so on through a simulation apparatus before being put into work; through training of the user, the loss due to the occurrence of defects may be considerably reduced so that the efficiency of the secondary battery production task may be improved effectively.

According to the invention, a simulation apparatus may generate and provide a condition adjustment training scenario related to the malfunction of a vision inspector for secondary battery production to the user; accordingly, the user may deal with a malfunction situation that may occur in an actual apparatus without help from others and may effectively learn how to respond to various situations.

In various embodiments of the present disclosure, a user may easily learn how to operate a secondary battery production apparatus through the simulation progressed step by step according to the user's task skill level.

In various embodiments of the present disclosure, a user may easily identify and process a training scenario for which the user lacks training; thus, the user may be trained only in the training scenario for which the user has low work skills.

The technical effects of the present disclosure are not limited to the technical effects described above, and other technical effects not mentioned herein may be understood clearly by those with ordinary knowledge in the art (referred to as a "person with ordinary skills") to which the present disclosure belongs from the appended claims.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF THE DRAWINGS

Embodiments of the present disclosure will be described with reference to the accompanying drawings described below, wherein similar reference numbers denote similar constituting elements, but the present disclosure is not limited thereto.
FIG. 1 illustrates an example in which a user uses a simulation apparatus according to an embodiment of the present disclosure.
FIG. 2 is a functional diagram illustrating an internal structure of a simulation apparatus according to an embodiment of the present disclosure.
FIG. 3 is a block diagram illustrating an example in which a simulation apparatus operates according to an embodiment of the present disclosure.
FIG. 4 illustrates an example of a display screen displayed or output on an apparatus operating unit according to an embodiment of the present disclosure.
FIG. 5 illustrates an example of a display screen displayed or output on an apparatus operating unit according to another embodiment of the present disclosure.
FIG. 6 illustrates an example of a display screen displayed or output on a defect checking unit according to an embodiment of the present disclosure.
FIG. 7 illustrates an example in which a crater overdetection defect scenario has occurred on a defect checking unit according to an embodiment of the present disclosure.
FIG. 8 illustrates an example in which an island undetection defect scenario has occurred on an apparatus operating unit according to an embodiment of the present disclosure.
FIG. 9 illustrates an example in which a labeler abnormality scenario has occurred according to an embodiment of the present disclosure.
FIG. 10 illustrates an example in which operational capability information and a test result are generated according to an embodiment of the present disclosure.
FIG. 11 illustrates an example of a simulation method for a vision inspector for secondary battery production according to an embodiment of the present disclosure.
FIG. 12 illustrates an example of a method of calculating a test result according to an embodiment of the present disclosure.
FIG. 13 illustrates an exemplary computing device for performing the method and/or embodiments.

### [Description of Reference numeral]

100: Simulation apparatus
110: User
120: Apparatus operating unit
130: Defect checking unit
140, 150: Detection adjustment unit

### MODES FOR IMPLEMENTING THE INVENTION

Hereinafter, specifics for embodiment of the present disclosure will be described in detail with reference to appended drawings.

In the accompanying drawings, identical or corresponding constituting elements are assigned the same reference numbers. In addition, overlapping descriptions of the same or corresponding constituting elements may be omitted in the description of the embodiments below. However, even if descriptions regarding a constituting element are omitted, it should not be interpreted that the constituting element is not included in the corresponding embodiment.

The advantages and features of the present disclosure, and a method of achieving them will be clearly understood with reference to the embodiments described together with appended drawings..

Terms used in the present disclosure will be briefly defined, and disclosed embodiments will be described in detail. Terms used in the present disclosure have been selected as much as possible from general terms relevant to the functions of the present disclosure and currently in wide use; however, the selection of terms may be varied depending on the intention of those persons skilled in the corresponding field, precedents, or emergence of new technologies. In addition, in a particular case, some terms may be selected arbitrarily by the applicant, and in this case, detailed definitions of the terms will be provided in the corresponding description of the present disclosure. Therefore, the terms used in the present disclosure should be defined not simply by their apparent name but based on their meaning and context throughout the present disclosure.

In the present disclosure, a singular expression should be understood to include a plural expression unless the context explicitly indicates a singular expression. In addition, a plural expression should be understood to include a singular expression unless the context explicitly indicates a plural expression. Throughout the disclosure, unless otherwise explicitly stated, if a particular element is said to include some particular element, it means that the former may further include other particular elements rather than exclude them.

The term "comprises (includes)" and/or "comprising (including)" used in the present disclosure indicates the existence of features, steps, operations, components, and/or constituting elements; however, the term does not exclude addition of one or more other functions, steps, operations, components, constituting elements, and/or a combination thereof.

In the present disclosure, when a particular constituting element is referred to as being "coupled to," "combined with," "connected to," "related to," or as "responding to" any other constituting element, the particular constituting element may be directly coupled to, combined with, connected to, and/or related to, or may directly respond to the other constituting element; however, the present disclosure is not limited to the relationship. For example, there may be one or more intermediate constituting elements between a particular constituting element and another constituting element. In addition, in the present disclosure, "and/or" may include one or more of the listed items or a combination of at least a portion of one or more of the listed items.

In the present disclosure, the terms such as "first" and "second" are introduced to distinguish one constituting element from the others, and thus the constituting element should not be limited by those terms. For example, a "first" constituting element may be used to indicate a constituting element in a form similar to or the same as a "second" constituting element.

In the present disclosure, a "secondary battery" may refer to the battery made using a material in which the redox process between a current and the material may be repeated several times. For example, to produce a secondary battery, processing such as mixing, coating, roll pressing, vision inspecting, slitting, notching and drying, lamination, folding and stacking, lamination and stacking, packaging, charging and discharging, degassing, folding, characteristics inspection, and the like may be performed. In this case, a separate apparatus for performing each process may be used. At this time, each equipment may be operated according to adjustment parameters and configuration values set or changed by a user.

In the present disclosure, a "user" may refer to a worker who performs secondary battery production and operates secondary battery production equipment and may include a user training through a simulation apparatus for secondary battery production equipment. In addition, a "user account" is an ID created to use the simulation apparatus or assigned to each user; the user may log into the simulation apparatus using the user account and perform a simulation, but the present disclosure is not limited thereto.

In the present invention, the "defect checking unit," "apparatus operating unit," and "detection adjustment unit" are software programs included in the simulation apparatus or displayed on an input/output device related to the simulation apparatus and/or an input/output device and may refer to a device and/or a program outputting an image or a video of a 3D model apparatus or receiving various inputs from a user and delivering the received inputs to the simulation apparatus.

Furthermore, in the present invention, the "3D model apparatus" is a virtual apparatus that implements actual secondary battery production equipment, which may operate in a way that images, videos, or animations of the virtual apparatus are executed, modified, and/or corrected based on the information input by a user. In other words, the "operation of the 3D model apparatus" may include images, videos, and animations of a virtual apparatus executed, modified, and/or corrected. For example, the 3D model apparatus may include apparatus for performing mixing, coating, roll pressing, vision inspecting, slitting, notching and drying, lamination, folding and stacking, lamination and stacking, packaging, charging/discharging, degassing, folding, characteristics inspection, and the like. Additionally or alternatively, the 3D model apparatus may be implemented as a 2D model apparatus. In other words, in the present disclosure, the 3D model apparatus is not limited to a 3D model but may include a 2D model. Accordingly, the 3D model apparatus may include terms such as a 2D model apparatus, an animation model apparatus, and a virtual model apparatus.

In the present disclosure, "user condition information" may include a user input that sets or modifies at least part of conditions and/or values among adjustment parameters or may correspond to the information generated by an arbitrary algorithm predetermined based on the corresponding user input. In the present disclosure, the user condition information may be input through a plurality of setting value input windows of the detection adjustment unit.

In the present disclosure, "user action information" may include a user input such as a touch input, a drag input, a pinch input, and a rotation input performed on at least part of the 3D model apparatus of the apparatus operating unit or may correspond to the information generated by an arbitrary algorithm predetermined based on the corresponding user input.

In the present invention, a "defect scenario" may be a scenario that changes the operation of a 3D model apparatus (vision inspector) to lie within a malfunction range or includes values or conditions for changing inspection quality by the 3D model apparatus to lie within an error range (overdetection, undetection). For example, when a defect scenario occurs during the operation of the simulation apparatus, the operation or inspection quality information of the 3D model apparatus may be changed based on the generated defect scenario. In addition, when the operation or inspection quality information of the 3D model apparatus changed by the defect scenario is corrected to lie within a normal range, the corresponding defect scenario may be determined as having been resolved.

In the present disclosure, the 'training scenario' may include a detailed step scenario for operating the secondary battery production equipment. For example, when the secondary battery production equipment is a vision inspector, the training scenario may include a vision inspection preparation training and a vision inspection adjustment training. In addition, the vision inspection preparation training may include an inspection specification checking step, a new model registration step, an inspection start step, and a detection history inquiry step. The vision inspection adjustment training may include a surface inspection adjustment training, an overlay adjustment training, and the like. The surface inspection adjustment training may include an image simulation step, a coating portion average brightness adjustment step, a surface defect detection setting step, an uncoated portion-coated portion boundary value setting step, a manual inspection area setting step, a manual mismatch area setting step, and the like, and the overlay adjustment training may include an image simulation step, an overlay defect detection setting step, a camera position adjustment step, a roll cleaning mode step, and the like.

In the present disclosure, a 'material' is an object to be inspected by the 3D model apparatus (vision inspector) and may include a slurry layer coated on a foil and an insulating layer coated overlapping at least a portion of the slurry layer. The 3D model apparatus may obtain images of a surface of the slurry layer and a surface of the insulating layer of the material and inspect whether coating defects have occurred in the slurry layer and the insulating layer through image processing.

In the present disclosure, 'inspection quality' may refer to quality of an inspection result when the 3D model apparatus (vision inspector) obtains the surface image of the material and inspects whether the coating is defective through image processing. That is, when the 3D model apparatus detects normal for a normal coating of the surface quality of the material, or when the 3D model apparatus detects a defect for a defective coating of the surface quality of the material, it may be referred to as normal detection. In addition, when the 3D model apparatus detects a defect for a normal coating of the surface quality of the material, it may be referred to overdetection, and when the 3D model apparatus detects normal for a defective coating of the surface quality of the material, it may be referred to as undetection.

In the present disclosure, the "mixing process" may be a process of producing slurry by mixing active material, a binder, and other additives with a solvent. For example, a user may determine or adjust the addition ratio of active material, conductive material, additives, and a binder to produce slurry of specific quality. In addition, in the present disclosure, the "coating process" may be a process of applying the slurry on the foil with a particular amount and shape. For example, a user may determine or adjust a coater apparatus's die or slurry temperature to perform coating with a quantity and a shape of specific quality.

In the present disclosure, the "roll pressing process" may be a process in which coated electrodes are passed between two rotating upper and lower rolls and pressed to a certain thickness. For example, a user may determine or adjust the spacing between rolls to maximize the cell capacity by increasing the electrode density through the roll pressing process. In addition, in the present disclosure, the "slitting process" may be a process of passing electrodes between two upper and lower rotating knives and cutting the electrodes to have a predetermined width. For example, a user may determine or adjust various adjustment parameters to maintain a constant electrode width.

In the present disclosure, a vision inspection process may be included before the roll press process or the slitting process, and the 'vision inspection process' may be a process of inspecting a surface coating state of the slurry layer or the insulating layer coated on the foil using a vision equipment. For example, in the vision inspection process, it is essential not to fail to detect (undetection) a defective coating area on the slurry layer or the insulating layer, or not to overdetect a normal coating as a defect, and a user may determine or set vision adjustment parameters to accurately detect a defective coating area on the slurry layer or the insulating layer.

In the present disclosure, the "notching and drying process" may be a process of removing moisture after punching out an electrode into a particular shape. For example, a user may determine or adjust a cutting height, a length and the like to punch the electrode into a particular shape with specific quality. In addition, in the present disclosure, the "lamination process" may be a process of sealing and cutting the electrode and the separator. For example, a user may determine or adjust a value corresponding to the x-axis and a value corresponding to the y-axis to perform cutting at a specific quality.

In the present disclosure, the "package process" may be a process of attaching a lead and a tape to an assembled cell and packaging the assembled cell in an aluminum pouch, and the 'degas process' may be a process of removing the gas generated in the cell due to a first charging and discharging of the packaged cell and re-sealing the cell. In addition, in the present disclosure, the 'folding process' may be a process of folding a side wing of the pouch before cell shipment, and the 'quality inspection process' may be a process of checking characteristics of the cell such as thickness, weight, width, length, insulation voltage, and the like using a measurement device. In the case of such a process, a user may adjust conditions, values, and the like of various adjustment parameters or change a setting value corresponding to an apparatus so that each process may be performed with a certain quality within a normal range.

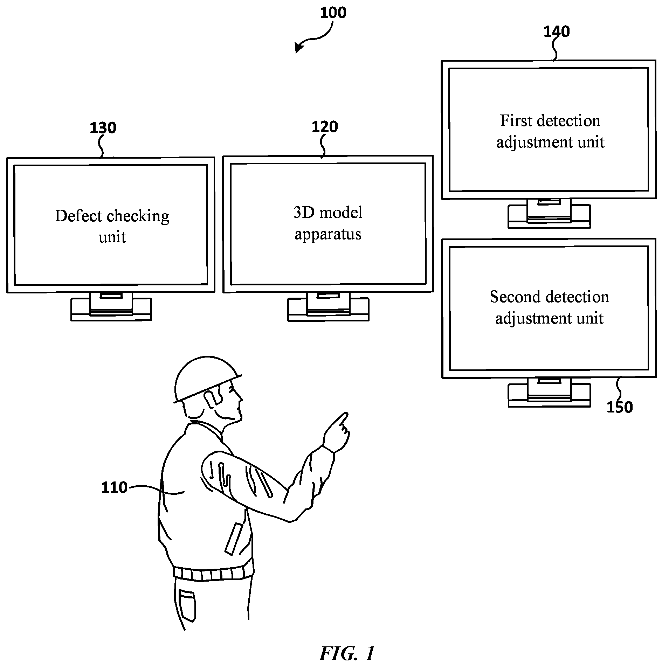

FIG. 1 illustrates an example in which a user 110 uses a simulation apparatus 100 according to an embodiment of the present disclosure. As illustrated in the figure, the simulation apparatus 100 is used for training a secondary battery production worker (e.g., user 110) and may include, for example, an apparatus operating unit 120, a defect checking unit 130, and detection adjustment units 140 and 150. For example, the user 110 may operate the simulation apparatus 100 which implements the actual secondary battery production equipment virtually (e.g., 2D, 3D, etc.) and learn how to use the secondary battery production equipment.

The apparatus operating unit 120 may include a 3D model apparatus related to the production of secondary batteries. Here, the 3D model apparatus may include, but not limited to, a 3D model related to secondary battery production equipment such as, but not limited to, a mixer, a coater, a roll presser, a vision inspector according to the invention, a slitter, a lamination apparatus, a lamination and stacking apparatus, and the like, and may further include a 3D model of any other apparatus used for the production of secondary batteries. According to an embodiment, when the 3D model apparatus is a vision inspector, the apparatus operation unit 120 may obtain a surface image of a material inspected by the 3D model apparatus. An accuracy of the surface image of the material obtained by the 3D model apparatus may be degraded according to a setting value of an adjustment parameter of the 3D model apparatus. Depending on the accuracy of the surface image of the material obtained by the 3D model apparatus, the surface defect of the material may not be detected or the normal surface of the material may be overdetected as a defect. In addition, the user 110 may manipulate the 3D model apparatus or change the configuration of the 3D model apparatus by applying a touch input, a drag input, or a pinch input to the 3D model apparatus (at least part of the 3D model apparatus) included in the apparatus operating unit 120. The user 110 may enlarge/reduce an arbitrary area of the 3D model apparatus through view switching. In addition, surface quality information on the surface of the material inspected by the 3D model apparatus may be guided, and the surface of the material inspected by the 3D model apparatus may be enlarged/reduced for the user to check the surface quality information of the material. Here, it is assumed that the apparatus operating unit 120 displays a 3D model apparatus related to secondary battery production; however, the present disclosure is not limited to the assumption, and thus, an apparatus related to a specific process in the secondary battery production process may be implemented and displayed as a 2D model apparatus.

According to an embodiment, the defect checking unit 130 may display information on a defective area of the material based on a result of analyzing an image of the material obtained from the 3D model apparatus. That is, as a result of analyzing the image of the material obtained from the 3D model apparatus, if an abnormal area exists and a size of the abnormal area exceeds a preset specification, the defect checking unit 130 determines that the abnormal area is a defective area, and if an abnormal area does not exist or a size of the abnormal area is within a preset specification, the defect checking unit 130 determines that it is normal. Here, the abnormal area may refer to an area in which average color, saturation, brightness, and the like of the material image differ by a preset threshold value or more. The types of defects detected by the defect checking unit 130 may include, for example, craters, lines, pin holes, dents, foil wrinkles, coating wrinkles, islands, protrusions, heated lines, coated surface area cracks, scratches, insulation lines, insulation pin holes, and insulation peel off, insulation non-coatings.

Here, the material may be a normal material (a material that does not include a defective area) or a defective material (a material that includes a defective area); when the 3D model apparatus operates normally, the normal material is inspected as normal and the defective material is detected as defect (normal detection), but when the 3D model apparatus does not operate normally, the normal material may be inspected as defect (overdetection) or the defective material may be detected as normal (undetection). Both overdetection and undetection may correspond to malfunctions of the 3D model apparatus (vision inspector). The defect checking unit 130 may display information on the defective area of the material based on the image processing result of the material obtained by the 3D model apparatus. When the information on the defective area of the material is displayed on the defect checking unit 130, the user may check the surface quality information of the material through the 3D model apparatus of the apparatus operating unit 120; when the defective area of the material displayed on the defect checking unit 130 is overdetected, the setting value of the adjustment parameter of the 3D model apparatus may be modified through the detection adjustment units 140 and 150. In addition, if the defect checking unit 130 fails to detect a defect in the material, but it is confirmed that the defect is undetected based on the surface quality information of the corresponding material through the 3D model apparatus of the apparatus operating unit 120, the setting value of the adjustment parameter of the 3D model apparatus may be modified through the detection adjustment units 140 and 150.

Here, the surface quality checking of the material may be displayed in association with the 3D model apparatus of the apparatus operating unit 120, checked by a specific operation of the 3D model apparatus, or additionally displayed on a screen of a partial area of the 3D model apparatus. For example, when a button for checking the surface quality displayed on the apparatus operating unit 120 is selected, the surface quality information of the material may be displayed as a pop-up screen or output. In another example, the surface quality information may be displayed or output in a manner of a color change of at least a partial area of the 3D model apparatus or an alarm.

According to an embodiment, the detection adjustment units 140 and 150 may include a plurality of adjustment parameters for determining an operation of the 3D model apparatus displayed on the apparatus operating unit 120, and the user 100 may execute, change, and/or correct the operation of the 3D model apparatus by changing at least part of conditions of the adjustment parameter. That is, the operation of the 3D model apparatus may be adaptively changed or corrected by a change in the adjustment parameter input by the user 110. A first detection adjustment unit 140 may include a setting value input window of an adjustment parameter of the 3D model apparatus for detecting a defect of a slurry layer (surface inspection) of a material, and a second detection adjustment unit 150 may include a setting value input window of an adjustment parameter of the 3D model apparatus for detecting a defect of an insulating layer (overlay) of the material.

With such a configuration, the user 110 performing secondary battery production may be trained in a method of preparing operation of the secondary battery production apparatus, a method of operating the secondary battery production apparatus, a method of handling a defect situation before being put into work, and the like; by training the user 110 as described above, user's equipment manipulation proficiency may increase, and loss due to the occurrence of defects may be considerably reduced, thereby improving the efficiency of the secondary battery production task effectively.

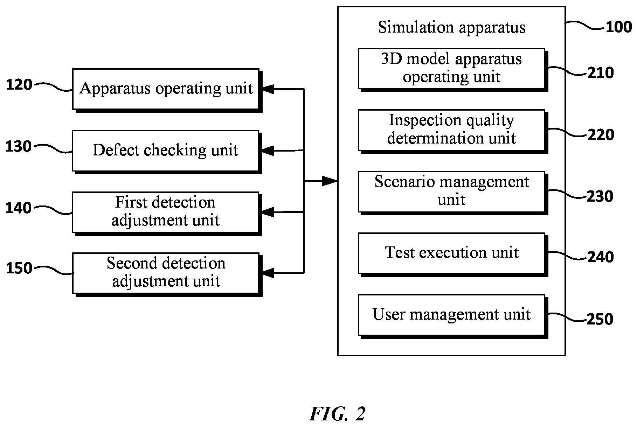

FIG. 2 is a functional diagram illustrating an internal structure of a simulation apparatus 100 according to an embodiment of the present disclosure. As illustrated in the figure, the simulation apparatus 100 (e.g., at least one processor of the simulation apparatus 100) may include, but not limited to, a 3D model apparatus operating unit 210, an inspection quality determination unit 220, a scenario management unit 230, a test execution unit 240, and a user management unit 250. The simulation apparatus 100 may communicate with the apparatus operating unit 120, the defect checking unit 130, and the detection adjustment units 140 and 150, and exchange data and/or information related to the 3D model apparatus.

The 3D model apparatus operating unit 210 may execute, change, and/or correct the operation of the 3D model apparatus displayed on the apparatus operating unit 120 according to a user's manipulation. In addition, the operation of the detection adjustment units 140 and 150 may be executed, changed and/or corrected based on the execution, change and/or correction of the operation of the model apparatus. According to an embodiment, the 3D model apparatus operating unit 210 may obtain or receive user action information and/or user condition information using information input from the user (e.g., a secondary battery production worker). Then, the 3D model apparatus operating unit 210 may determine or change the operation of the 3D model apparatus using the obtained or received user action information and/or user condition information.

According to an embodiment, the user action information is generated based on a user input such as touching and/or dragging at least part of an area of the 3D model apparatus included in the apparatus operating unit 120 and may include information on an amount of change in a setting value of the 3D model apparatus according to the user input. For example, when the 3D model apparatus is a vision inspector for secondary battery production, the user may touch various hardware (lights, cameras, encoders, labelers, etc.) constituting the 3D model apparatus to check whether there is an abnormality and may drag to move the position or exchange the hardware. In addition, a specific area of the vision inspector may be touched to enlarge or reduce the corresponding area, and a material area to be inspected by the vision inspector may be touched to enlarge or reduce the material and check surface quality information of the material. In this case, user action information based on each hardware, specific area, and material area may be generated.

According to an embodiment, the user condition information is information generated based on a user input that changes conditions and/or values of at least part of parameters among a plurality of adjustment parameters included in the detection adjustment units 140 and 150 and may include information on an amount of change in a condition value to determine the operation of the 3D model apparatus according to the user input. For example, when the 3D model apparatus is a vision inspector for secondary battery production, the user may change, for example, a brightness threshold value and a boundary setting value of a coating portion to a predetermined value; in this case, user condition information based on the changed value of the brightness threshold value and the boundary setting value may be generated.

As described above, when the operation of the 3D model apparatus is executed based on the user condition information and/or the user action information, the inspection quality determination unit 220 may determine or generate quality information related to the inspection quality of the 3D model apparatus. In other words, the inspection quality information of the 3D model apparatus may be determined or generated differently according to whether there is an abnormality of in hardware, a setting value or a condition value of the corresponding 3D model apparatus. In other words, the user may change or adjust the inspection quality of the 3D model apparatus by changing adjustment parameters or setting at least part of an area of the corresponding 3D model apparatus by a touch input. Depending on the inspection quality of the 3D model apparatus, the 3D model apparatus may have malfunctions such as undetection in which a defective area of the material is detected as normal and overdetection in which a normal area of the material is detected as a defective area, or may perform normal detection in which the defective area of the material is detected as a defective area and the normal area of the material is detected as normal.

According to an embodiment, the inspection quality determining unit 220 may determine or extract one or more quality parameters for determining the inspection quality of the 3D model apparatus, and, while the operation of the 3D model apparatus is in execution, may calculate a value corresponding to each of the one or more quality parameters determined based on the operation of the 3D model apparatus being executed. Here, the value corresponding to the quality parameter may be calculated by an arbitrary predetermined algorithm. Also, the inspection quality determining unit 220 may generate quality information related to the inspection quality by the 3D model apparatus based on the calculated values corresponding to the one or more quality parameters, respectively. For example, if the 3D model apparatus is a vision inspector, when the user adjusts the brightness threshold value, a size of the abnormal area may be calculated by comparing a difference between an average brightness value of the obtained material image and a brightness value of the inspection area and the brightness threshold value. These abnormal areas are compared to the size of the specification, which may be sometimes determined to be defective or normal.

According to an embodiment, the scenario management unit 230 may determine one or more training scenarios from among a plurality of training scenarios of the 3D model apparatus, and, based on the determined one or more training scenarios, may change at least one of an operation of the 3D model apparatus or quality information related to a surface quality of the material. For example, if the 3D model apparatus is a vision inspector, the training scenario may include a vision inspection preparation training and a vision inspection adjustment training. The vision inspection preparation training may include an inspection specification checking step, a new model registration step, an inspection start step, and a detection history inquiry step. The vision inspection adjustment training may include a surface inspection adjustment training, an overlay adjustment training, and the like. The surface inspection adjustment training may include an image simulation step, a coating portion average brightness adjustment step, a surface defect detection setting step, an uncoated portion-coated portion boundary value setting step, a manual inspection area setting step, a manual mismatch area setting step, and the like, and the overlay adjustment training may include an image simulation step, an overlay defect detection setting step, a camera position adjustment step, a roll cleaning mode step, and the like.

According to an embodiment, when a training scenario is generated, the user may change the adjustment parameter or change the settings of the 3D model apparatus in order to proceed with the generated training scenario. In this case, the scenario management unit 230 may receive at least one of user action information or user condition information to perform one or more determined training scenarios, and, based on at least one of the received user action information or user condition information, may change an operation of the 3D model apparatus. In addition, the scenario management unit 230 may calculate a value corresponding to each of a plurality of quality parameters related to inspection quality according to the operation and setting of the 3D model apparatus being executed while the operation of the changed 3D model apparatus is in execution, and may correct inspection quality information related to the inspection quality of the changed 3D model apparatus based on the calculated value corresponding to each of the plurality of quality parameters. Then, the scenario management unit 230 may determine whether one or more training scenarios have been completed using the corrected inspection quality information.

In addition, the scenario management unit 230 may determine one or more defect scenarios from among a plurality of defect scenarios associated with a malfunction of the 3D model apparatus, and based on the determined one or more defect scenarios, may change at least one of the operation of the 3D model apparatus or the inspection quality information related to the inspection quality of the 3D model apparatus. For example, when the 3D model apparatus is a vision inspector, the plurality of defect scenarios may include a surface inspection overdetection scenario, a surface inspection undetection scenario, an overlay abnormality scenario, a hardware abnormality scenario, and the like. The surface inspection overdetection scenario may include a crater overdetection scenario, a pinhole overdetection scenario, a bound region line overdetection scenario, a roller tip overdetection scenario, a bound region island overdetection scenario, a fine coating edge setting overdetection scenario, and the like. The surface inspection undetection scenario may include a crater undetection scenario, a pinhole undetection scenario, a bound region line undetection scenario, a line undetection scenario, an island undetection defect scenario, and the like. In addition, the overlay abnormality scenario may include an insulation coating width abnormality scenario, an insulation pinhole overdetection scenario, an overlay width abnormality scenario, an insulation pinhole undetection scenario, and the like. In addition, the hardware abnormality scenario may include a lighting abnormality scenario, a camera abnormality scenario, an encoder abnormality scenario, a labeler abnormality scenario, a program down occurrence scenario, and the like.

In this case, the scenario management unit 230 may determine a defect scenario by extracting at least one of the surface inspection overdetection scenario, the surface inspection undetection scenario, the overlay abnormality scenario, or the hardware abnormality scenario, and based on the extracted or determined defect scenario, may change the adjustment parameters and operation of the 3D model apparatus, the surface quality information of the material, and the inspection quality information.

For example, when the surface inspection overdetection scenario occurs, the surface quality information of the material may be maintained in a normal state, and the adjustment parameters, operation, and inspection quality information of the 3D model apparatus may be modified into a malfunctioning state. In addition, when the surface inspection undetection scenario occurs, the surface quality information of the material may be modified into a defective state, and the adjustment parameters, operation and inspection quality information of the 3D model apparatus may be modified into a malfunctioning state.

According to an embodiment, when a defect scenario occurs, the user may change the adjustment parameter or the settings of the 3D model apparatus to resolve the defect scenario that has occurred. In this case, the scenario management unit 230 may receive at least one of user action information or user condition information for resolving the determined one or more defect scenarios and, based on at least one of the received user action information or user condition information, may correct the operation of the changed 3D model apparatus. In addition, while the operation of the corrected 3D model apparatus is in execution, the scenario management unit 230 may calculate a value corresponding to each of the plurality of quality parameters related to the inspection quality of the 3D model apparatus based on the operation of the 3D model apparatus in execution and, based on the calculated value corresponding to each of the plurality of quality parameters, may correct the inspection quality information related to the inspection quality of the corrected 3D model apparatus.

Then, the scenario management unit 230 may determine whether one or more defect scenarios have been resolved using the corrected inspection quality information. For example, when a difference between surface quality information of the material and the inspection quality information detected based on the image of the material obtained by the 3D model apparatus is within a normal range, the scenario management unit 230 may determine that the defect scenario has been resolved; however, the present disclosure is not limited thereto, and when a value calculated by providing each quality parameter to an arbitrary algorithm corresponds to a predetermined normal range, the scenario management unit 230 may determine that the defect scenario has been resolved.

According to an embodiment, the test execution unit 240 may determine whether one or more defect scenarios have been resolved using the corrected quality information; when it is determined that one or more defect scenarios have been resolved, the test execution unit 240 may calculate a progress time and a loss value of one or more defect scenarios while one or more defect scenarios are in progress. For example, the loss value may be calculated through a predetermined, arbitrary algorithm based on a user's response time, a user input value, and the like. In addition, the test execution unit 240 may generate operational capability information of the 3D model apparatus for a user account based on the calculated progress time and loss value. Here, the user account may refer to an account of a worker who uses the simulation apparatus 100, and the operational capability information represents the work skill level of the user, which may include a work speed, degree of proximity to a target value, and an evaluation score. Additionally, when the corresponding user solves all predetermined types of defect scenarios, the test execution unit 240 may determine whether the user passes a simulation training based on the operational capability information for each defect scenario.

The user management unit 250 may perform management such as registration, modification, and deletion of a user account related to a user who uses the simulation apparatus 100. According to an embodiment, the user may use the simulation apparatus 100 using the user's registered user account. In this case, the user management unit 250 may store and manage information on whether each training scenario has been performed, whether each defect scenario has been resolved and operational capability information for dealing with each defect scenario in an arbitrary database for each user account. Using the information stored by the user management unit 250, the scenario management unit 230 may extract information related to a specific user account stored in the database and extract or determine at least one scenario among a plurality of training scenarios and defect scenarios based on the extracted information. For example, the scenario management unit 230 may extract only a training scenario or defect scenario in which the working speed is lower than an average working speed based on the information related to the user account or provide the extracted defect scenario to the corresponding user, but the present disclosure is not limited to the specific operation; the defect scenario may be extracted or determined by another arbitrary criterion or a combination of arbitrary criteria.

In FIG. 2, it is assumed that functional configurations included in the simulation apparatus 100 are different from each other; however, the assumption is intended only to help understand the disclosure, and one computing device may perform two or more functions. In addition, the simulation apparatus 100 of FIG. 2 assumes to be distinguished from the apparatus operating unit 120, the defect checking unit 130, and the detection adjustment units 140 and 150; however, the present disclosure is not limited to the assumption, and the apparatus operating unit 120, the defect checking unit 130, and the detection adjustment units 140 and 150 may be included in the simulation apparatus 100. Using the configuration above and in accordance with the invention, the simulation apparatus 100 generates a defect scenario having various values related to the malfunction of the secondary battery production equipment and provide the generated scenarios to the user; accordingly, the user may be trained in a method of resolving a malfunction situation that occurs in an actual apparatus without help from others and effectively learn how to respond to each situation.

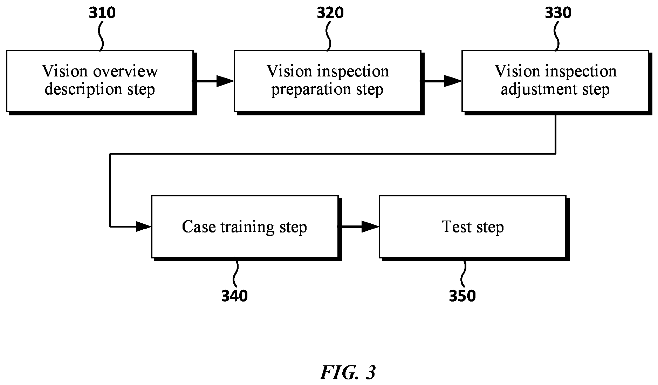

FIG. 3 is a block diagram illustrating an example in which a simulation apparatus 100 operates according to an embodiment of the present disclosure. As illustrated in the figure, the simulation apparatus (100 in FIG. 1) may operate through processes such as a vision overview description step 310, a vision inspection preparation step 320, a vision inspection adjustment step 330, a case training step 340, and a test step 350. In other words, the user may be trained in a method of operating secondary battery production equipment through the steps 310, 320, 330, 340, 350, and a level test step for a novice user to evaluate operation capability before simulation learning may be added and proceed before the vision overview description step 310.

The vision overview description step 310 may be a step of learning a vision hardware overview, a vision software overview, and a detection defect type. For example, the vision hardware overview may include configuration, type, position, and operation method of the vision inspector's hardware (e.g., a camera for surface inspection, a camera for overlay, and an encoder). The vision software overview may include configuration of a software of the vision inspector (e.g., a master software driven by the defect checking unit, a surface inspection software driven by the first detection adjustment unit, and an overlay software driven by the second detection adjustment unit), types and principles of adjustment parameters, a method of manipulating the adjustment parameters, and the like. The detection defect type may include a description of the defect type of the defective area detected by the vision inspector. For example, the type of the defect detected by the defect checking unit 130 including craters, lines, pin holes, dents, foil wrinkles, coating wrinkles, islands, protrusions, heated lines, coated surface area cracks, scratches, insulation lines, insulation pin holes, and insulation peel off, insulation non-coatings, and the like may be described. While the vision overview description step 310 is being performed, if the user touches any button for a predetermined time or inputs a correct value corresponding to an arbitrary parameter, it may proceed to the next step, or a button that leads to the next step (e.g., NEXT button) may be displayed or activated.

The vision inspection preparation step 320 may be a training scenario execution step based on the operation preparation process of the secondary battery production apparatus, and may be a step in which the user learns items to be checked or manipulated before operating the secondary battery production apparatus. For example, when the 3D model apparatus is a vision inspector, the vision inspection preparation step 320 may include an inspection specification checking step, a new model registration step, an inspection start step, a detection history inquiry step, and the like. The inspection specification checking step may be a step of learning how to check the detection specification in the defect checking unit. The new model registration step may be a step of learning how to set a recipe (width, number of lanes, mismatch specifications, etc.) for a new production model in the defect checking unit. The inspection start step may be a step of learning, after checking the inspection specification and setting the recipe for the new production model, how to start an inspection based on the corresponding information. The detection history inquiry step may be a step of learning how to inquire of a history in which a defect is detected. According to the scenario of each training step, the 3D model apparatus may be operated, and guide information on the type of the adjustment parameter, the value of the adjustment parameter and the like to be checked and set may be displayed or output. That is, at least part of an area of screens of the apparatus operating unit 120, the defect checking unit 130, and the detection adjustment unit 140, 150 to be checked and set by the user may be turned on or activated. In this case, the user may manipulate the apparatus operating unit 120, the defect checking unit 130, and the detection adjustment units 140 and 150 corresponding to the guide information and input a setting value, and when one operation is completed, it may proceed to the next step, or a button that leads to the next step (e.g., NEXT button) may be displayed or activated. Accordingly, the user may be trained in the vision inspection preparation process for the vision inspector for secondary battery production based on the displayed information.

The vision inspection adjustment step 330 may be a training scenario execution step based on the operation process of the secondary battery production apparatus, and may be a step of learning changes in inspection quality of the 3D model apparatus depending on the adjustment parameter values of the detection adjustment units 140 and 150 and an operation state of the apparatus operation unit 120. The vision inspection adjustment step 330 may include a surface inspection adjustment step and an overlay adjustment step.

The surface inspection adjustment step may include an image simulation step, a coating portion average brightness adjustment step, a surface defect detection setting step, an uncoated portion-coated portion boundary value setting step, a manual inspection area setting step, a manual mismatch area setting step, and the like. The image simulation step of the surface inspection adjustment step may be a step of learning a process of loading and checking an image detected as a surface defect on the first detection adjustment unit 140 as a description of basic function to handle undetection/overdetection. The coating portion average brightness adjustment step may be a step of learning a process of adjusting an average brightness value of the coating portion according to the type of the material (polarity/model). The surface defect detection setting step may be a step of learning a description of a brightness threshold value and a guideline for setting the brightness threshold value. The uncoated portion-coated portion boundary value setting step may be a step of learning a process of setting a boundary value between an uncoated portion and a coated portion. The manual inspection area setting step may be a step of learning a process of manually setting an uncoated portion-coated portion boundary surface. The manual mismatch area setting step may be a step of learning a process of manually setting a mismatch area when the mismatch area is not automatically recognized.

The overlay adjustment step may include an image simulation step, an overlay defect detection setting step, a camera position adjustment step, a roll cleaning mode step, and the like. The image simulation step of the overlay adjustment step may be a step of learning a process of loading and checking an image detected as an overlay defect on the second detection adjustment unit 150 as a description for basic function to handle undetection/overdetection. The overlay defect detection setting step may be a step of describing a brightness threshold value and learning a guideline for setting the brightness threshold value. The camera position adjustment step may be a step of learning how to automatically transfer a camera to an overlay area and how to manually transfer the camera when automatic transfer is not possible. The roll cleaning mode step may be a step of learning a process of transferring the camera and encoder to an edge during roll cleaning.

According to the scenario of each training step, the 3D model apparatus may be operated, and guide information may be displayed or output on the type of the adjustment parameter, the value of the adjustment parameter to be checked and set.

That is, at least part of an area of screens of the apparatus operating unit 120, the defect checking unit 130, and the detection adjustment unit 140, 150 to be checked and set by the user may be turned on or activated. In this case, the user may manipulate the apparatus operating unit 120, the defect checking unit 130, and the detection adjustment units 140 and 150 corresponding to the guide information and input a setting value, and when one operation is completed, it may proceed to the next step, or a button that leads to the next step (e.g., NEXT button) may be displayed or activated. Accordingly, the user may be trained in the vision inspection adjustment process of the vision inspector for secondary battery production based on the displayed information.

The case training step 340 may be a step in which the user learns how to check and take action on malfunctions of the 3D model apparatus that occur during the operation of the secondary battery production apparatus and an error in inspection quality resulting therefrom. For example, in the case of the vision inspector, a plurality of defect scenarios may include a surface inspection overdetection scenario, a surface inspection undetection scenario, an overlay abnormality scenario, a hardware abnormality scenario and the like; upon occurrence of the defect, guide information such as the type of adjustment parameter, the value of the adjustment parameter, and the setting value of the 3D model apparatus to be adjusted to resolve the defect may be displayed or output. That is, at least part of an area of screens of the apparatus operating unit 120, the defect checking unit 130, and the detection adjustment unit 140, 150 to be checked and set by the user may be turned on or activated. In this case, the user may manipulate the apparatus operating unit 120, the defect checking unit 130, and the detection adjustment units 140 and 150 corresponding to the guide information and input a setting value, and when one operation is completed, it may proceed to the next step, or a button that leads to the next step (e.g., NEXT button) may be displayed or activated. Accordingly, the user may process the defect based on the displayed information and learn a defect solving method.

The case training step 340 may be a step in which a user repeatedly processes or resolves each defect scenario or a combination of a plurality of defect scenarios related to a secondary battery production apparatus to master a defect-solving method. For example, the user may directly select one defect scenario among a plurality of defect scenarios and be trained in the selected scenario, but the present disclosure is not limited to the operation; the user may be trained in a defect scenario determined randomly by the simulation apparatus. In such a case, in the case training step 340, guide information including condition information and action information required to solve each defect according to a defect scenario may be displayed or output. Here, when a user manipulates a specific adjustment parameter or changes the setting value of the 3D model apparatus, the operation of the 3D model apparatus and the inspection quality of the 3D model apparatus may be changed in real-time. By checking the changed inspection quality, the user may resolve the defect scenario through repeated training and improve the skill in coping with the defect.

The test step 350 may be a step of evaluating the operational capability of a user by testing the process through which the user completes the training scenario and the defect scenario. For example, when a user completes each training scenario and defect scenario, the operational capability of the user may be measured or evaluated based on, for example, a progress time and a loss value for each training scenario and defect scenario. The user may additionally learn or be trained for an incomplete training scenario and defect scenario by checking the operational capability and whether the user has passed the test. The test step 350 may additionally determine the degree of improvement of the user's skill level by comparing it with a performance evaluation score before simulation training measured in the user's level test step.

Although FIG. 3 assumes that each step is sequentially performed, the present disclosure is not limited to the assumption, and some of the steps may be omitted. In addition, the order of performing the steps may be changed and may be repeated. For example, after the testing step 350, the vision inspection adjustment step 330 and the case training step 340 may be performed again. Based on the configuration, the user may easily learn how to operate the secondary battery production apparatus through the simulation progressed step by step according to the user's task skill.

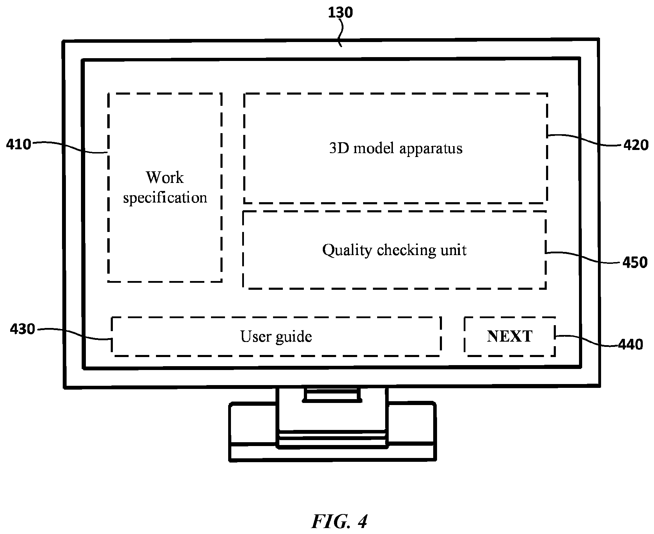

FIG. 4 illustrates an example of a display screen displayed or output on an apparatus operating unit 120 according to an embodiment of the present disclosure. As illustrated in the figure, the apparatus operating unit 120 may display or output text, an image, and a video including a work specification 410, a 3D model apparatus 420, a user guide 430, a NEXT button 440, and a quality checking unit 450 on the display screen. FIG. 4 assumes that the work specification 410, the 3D model apparatus 420, the user guide 430, the NEXT button 440, the quality checking unit, and the like are displayed in a specific area on the display screen, but the present disclosure is not limited to the assumption; each of the text, image, and video may be displayed in an arbitrary area of the display screen and may overlap each other. Additionally, a table of contents of the training step and the detailed training step may be further displayed on the apparatus operating unit 120.

The work specification 410 which is a document containing initial setting values and condition values of the 3D model apparatus 420 and may be predetermined or generated by a particular algorithm. For example, the simulation apparatus may receive and provide the contents of the work specification used to operate actual secondary battery production equipment or generate a new work specification by calculating the initial setting values and condition values of the 3D model apparatus 420 based on a plurality of input work specifications. The work specification may be continuously displayed on the apparatus operating unit 120, or may be displayed in a pop-up form on the 3D model apparatus when the user touches a work specification selection button, and then may be removed from the 3D model apparatus when the user touches the work specification selection button again.

The 3D model apparatus 420 may be a 3D image or video that implements the secondary battery production equipment in a 3D form. For example, the 3D model apparatus 420 may operate based on the user condition information and/or user action information input from a user.

The user guide 430 may be the information for guiding a user's next action, which includes information necessary to operate the 3D model apparatus 420, user condition information and user action information required to solve a training scenario, and so on. In other words, even when the user does not know how to operate the simulation apparatus, the user may be trained in a method of operating the simulation apparatus using the user guide 430.

When the condition value or setting value of the 3D model apparatus is determined or the 3D model apparatus 420 is operated using the displayed user guide 430, the corresponding step is resolved, and the NEXT button 440 for proceeding to the next step may be activated. The user may select the activated NEXT button 440 through, for example, a touch input to perform training corresponding to the next step.

The quality checking unit 450 may display or output quality information related to the surface quality of the material inspected by the 3D vision inspector. A slurry layer and an insulating layer may be displayed in image for the material inspected by the 3D vision inspector, and in some cases, the defect type of the defective area of the material detectable by the vision inspector may be displayed in image or the like. For example, in normal slurry layer and insulating layer images, images of a defective area such as craters, lines, pin holes, dents, foil wrinkles, coating wrinkles, islands, protrusions, heated lines, coated surface area cracks, scratches, insulation lines, insulation pin holes, and insulation peel off, insulation non-coatings, and the like may be displayed. The quality checking unit 450 may be displayed or output in a pop-up form overlaid on the screen of the 3D model apparatus 420.

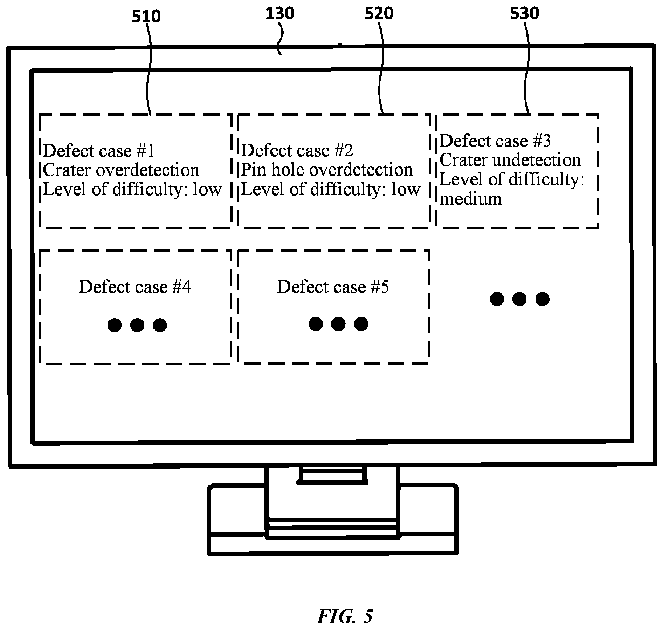

FIG. 5 illustrates an example of a display screen displayed or output on an apparatus operating unit 120 according to another embodiment of the present disclosure. As illustrated in the figure, the apparatus operating unit 120 may display or output text, an image, or a video including a plurality of defect scenarios 510, 520, 530 on the display screen. FIG. 5 assumes that a first defect scenario 510, a second defect scenario 520, and a third defect scenario 530 are displayed in specific areas on the display screen, but the present disclosure is not limited to the assumption; each text, image, or video may be displayed in any position on the display screen.

According to an embodiment, each defect scenario may include details and the level of difficulty of the defect scenario. For example, the first defect scenario 510 may be a crater overdetection defect with a low level of difficulty, the second defect scenario 520 may be a pin hole overdetection defect with a low level of difficulty, and the third defect scenario 530 may be a crater undetection defect with a medium level of difficulty. A user may select at least part of the plurality of defect scenarios 510, 520, 530 displayed on the display screen through a touch input to perform training based on the selected defect scenario. When one defect scenario is selected, a countermeasure and the like for the corresponding scenario may be additionally guided.

Additionally or alternatively, one defect scenario among the plurality of defect scenarios 510, 520, 530 may be determined by a predetermined algorithm. For example, through a user account (or information related to the user account) of a user performing training, the simulation apparatus may determine a defect scenario for which the user is not fully skilled or a combination of defect scenarios. Here, the user's work skill level may be calculated or determined as a test result for each defect scenario, but the present disclosure is not limited to the specific scheme. Based on the configuration, the user may easily identify and process a defect scenario for which the user lacks training; thus, the user may be trained only in the defect scenario for which the user has low work skills.

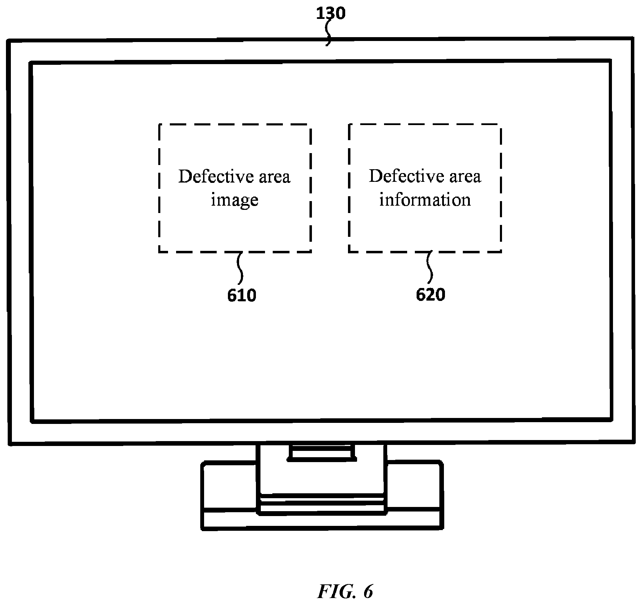

FIG. 6 illustrates an example of a display screen displayed or output on a defect checking unit 130 according to an embodiment of the present disclosure. According to an embodiment, the defect checking unit 130 may include a defective area image 610 which is detected as a defective area by signal-processing a surface image of the material obtained from the 3D model apparatus, and defective area information 620 including information such as a lane number in which the defective area occurs, an occurrence location (upper/lower) and a type of the defect. Such defective area information may be displayed as an image, color, or text. For example, the number may refer to a lane number, and the color of the number may refer to the location (upper/lower). The defective area image 610 and the defective area information 620 may be displayed being superimposed with each other.

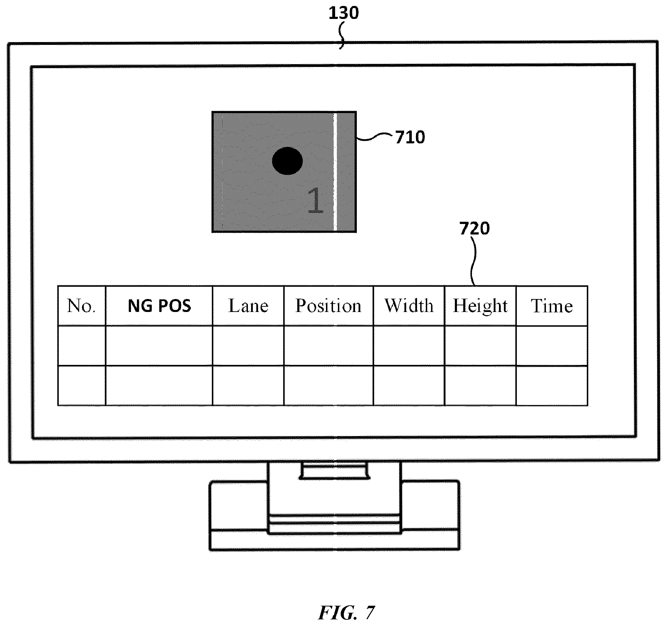

FIG. 7 illustrates an example in which a crater overdetection defect scenario has occurred on a defect checking unit 130 according to an embodiment of the present disclosure. As described above, in the case training step, the simulation apparatus (100 of FIG. 1) may determine one or more defect scenarios among a plurality of defect scenarios related to a malfunction of the 3D vision inspector and, based on the determined one or more defect scenarios, may change at least one of the operation or the quality information related to the inspection quality of the 3D vision inspector. Here, the plurality of defect scenarios may include a crater overdetection defect scenario. For example, the crater overdetection defect scenario may refer to a scenario in which an abnormal area on a surface of a material is smaller than a size determined by a preset specification, but an error occurs in the 3D model apparatus and it is detected as a defective area. As such, when the crater overdetection defect scenario occurs, a defective area image and defective area information 710 based on the crater defect are displayed on the defect checking unit 130, and defect log information 720 detected by the simulation apparatus is displayed in table.

According to an embodiment, when the determined one or more defect scenarios include the crater overdetection defect scenario, the simulation apparatus may display the crater defective area image and defective area information, and may further display log information, on the defect checking unit 130 as illustrated in FIG. 7. In addition, the apparatus operating unit 120 may output a guide to check a defect detection result through the defect checking unit 130, and output a guide that the corresponding defect detection result is due to overdetection.

When the crater overdetection defect scenario occurs, the user may follow the guide displayed on the apparatus operating unit 120 and check a crater defect in the defect checking unit 130. In addition, the user may check that the corresponding crater defect is a defect indication due to overdetection through the apparatus operating unit 120 or may check that the corresponding crater defect is a defect indication due to overdetection by enlarging the material area through touching or dragging of a material area inspected by the apparatus operating unit 120.

In addition, the user may adjust a setting value of a surface inspection parameter (e.g., a coating portion dark value) of the first detection adjustment unit 140 to cope with the occurrence of crater defects due to overdetection. For example, by increasing the coating portion dark value to reduce a size of an abnormal area recognized as a crater, overdetection of the crater may be alleviated. When adjustment of a mechanical part is required, the crater overdetection defect scenario may be coped with by touching or dragging a specific area of the 3D vision inspector displayed on the apparatus operating unit 120. In other words, the simulation apparatus may correct the inspection quality of the vision inspector in response to receiving, from the user, user condition information corresponding to the surface inspection parameter. Optionally or alternatively, the simulation apparatus may correct the inspection quality of the vision inspector in response to receiving, from the user, user action information of touching or dragging a specific area of the mechanical part for resolving the crater overdetection defect.

Then, the simulation apparatus may determine whether the crater overdetection defect scenario has been resolved based on the inspection quality of the corrected vision inspector. For example, when at least one of the user action information or the user condition information is generated based on a touch input or a drag input to a predetermined area in a predetermined order that may be used when resolving the crater overdetection defect scenario, or when a predetermined surface inspection parameter setting value is input, the simulation apparatus may determine that the crater overdetection defect scenario has been resolved. In other words, when the inspection quality of the vision inspector is corrected based on at least one of the corresponding user action information or user condition information, the simulation apparatus may determine that the crater overdetection defect scenario has been resolved. When it is determined that the defect scenario has been resolved, the crater defect displayed on the defect checking unit 130 may be deleted.

Similar to the crater overdetection defect scenario described above, the pinhole overdetection scenario, the bound region line overdetection scenario, the roller tip overdetection scenario, the bound region island overdetection scenario, and the fine coating edge setting overdetection scenario may be a scenario in which the vision inspector detects a normal area of the material as a defective area and displays it on the defect checking unit. When the corresponding overdetection defect scenario occurs, the user may recognize that it is a defect scenario due to overdetection through the defect checking unit and the apparatus operating unit, and may respond to the overdetection defect scenario by adjusting the setting value of the surface inspection parameter of the first detection adjustment unit.

In addition, the insulation pinhole overdetection scenario among the overlay abnormality scenarios may also be a scenario in which the vision inspector detects a normal area of the insulating layer of the material as a defective area and displays it on the defect checking unit. When the corresponding overlay overdetection scenario occurs, the user may recognize that it is a defect scenario due to overdetection through the defect checking unit and the apparatus operating unit and may respond to the corresponding overdetection defect scenario by adjusting the setting value of the overlay parameter of the second detection adjustment unit.

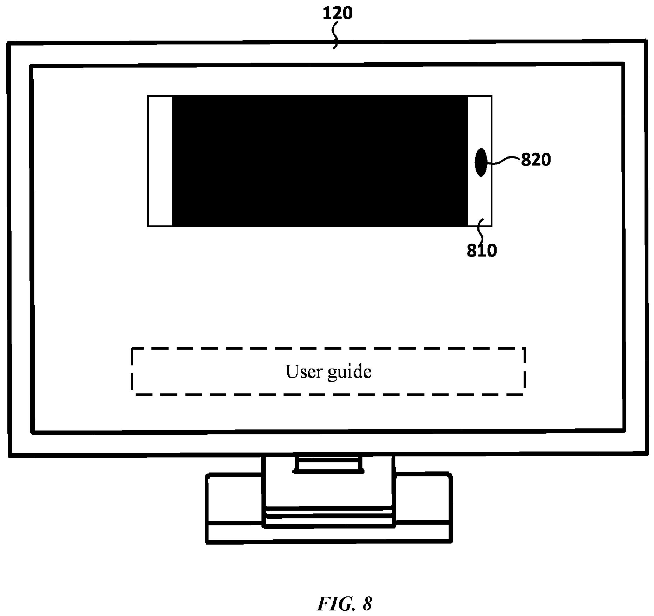

FIG. 8 illustrates an example in which an island undetection defect scenario has occurred on an apparatus operating unit 120 according to an embodiment of the present disclosure. As described above, in the case training step, the simulation apparatus (100 of FIG. 1) may determine one or more defect scenarios among a plurality of defect scenarios related to a malfunction of the 3D vision inspector and, based on the determined one or more defect scenarios, may change at least one of the operation or the quality information related to the inspection quality of the 3D vision inspector. Here, the plurality of defect scenarios may include an island undetection defect scenario. For example, the island undetection defect scenario may refer to a scenario in which a partial area (island) 820 on a surface of an uncoated portion 810 of a material is coated, but an error occurs in the 3D model apparatus and it is not detected as a defective area. As such, when the island undetection defect scenario occurs, an island is displayed on a surface image of a material displayed on the apparatus operating unit 120, and a guide indicating that an island defect has occurred, but the vision inspector has not detected it may be output on the user guide.

According to an embodiment, when the determined one or more defect scenarios include the island undetection defect scenario, the simulation apparatus may display the island defect image superimposed with the material image on the apparatus operating unit 120 as illustrated in FIG. 8. In addition, the apparatus operating unit 120 may output a guide informing that an island defect has occurred, but an undetection error has occurred in the vision inspector.

When the island undetection defect scenario occurs, the user may check an occurrence of an island defect of the material and undetection of the vision inspector in the apparatus operating unit 120 and the defect checking unit 130 according to the guide displayed on the apparatus operating unit 120. The user may check an occurrence of the island defect of the material by enlarging a material area inspected by the apparatus operating unit 120 through touching or dragging of the corresponding material area.

In addition, the user may adjust a setting value of a surface inspection parameter (e.g., an uncoated portion dark value) of the first detection adjustment unit 140 to cope with undetection of the island. For example, by decreasing the uncoated portion dark value to increase a size of an abnormal area which has been recognized as normal, undetection of the island may be alleviated. When adjustment of a mechanical part is required, the island undetection defect scenario may be coped with by touching or dragging a specific area of the 3D vision inspector displayed on the apparatus operating unit 120. In other words, the simulation apparatus may correct the inspection quality of the vision inspector in response to receiving, from the user, user condition information corresponding to the surface inspection parameter. Optionally or alternatively, the simulation apparatus may correct the inspection quality of the vision inspector in response to receiving, from the user, user action information of touching or dragging a specific area of the mechanical part for resolving the island undetection defect.

Then, the simulation apparatus may determine whether the island undetection defect scenario has been resolved based on the inspection quality of the corrected vision inspector. For example, when at least one of the user action information or the user condition information is generated based on a touch input or a drag input to a predetermined area in a predetermined order that may be used when resolving the island undetection defect scenario, or when a predetermined surface inspection parameter setting value is input, the simulation apparatus may determine that the island undetection defect scenario has been resolved. In other words, when the inspection quality of the vision inspector is corrected based on at least one of the corresponding user action information or user condition information, the simulation apparatus may determine that the island undetection defect scenario has been resolved. When it is determined that the defect scenario has been resolved, the island defect of the material displayed on the defect checking unit 130 may be deleted.

Similar to the island undetection defect scenario described above, the crater undetection scenario, the pinhole undetection scenario, the bound region line undetection scenario, and the line undetection scenario may be a scenario in which the vision inspector detects a defective area of the material as a normal area and fails to detect it as a defective area. When the corresponding undetection defect scenario occurs, the user may recognize that it is a defect scenario due to undetection through the defect checking unit and the apparatus operating unit, and may respond to the undetection defect scenario by adjusting the setting value of the surface inspection parameter of the first detection adjustment unit.

In addition, the insulation pinhole undetection scenario among the overlay abnormality scenarios may also be a scenario in which the vision inspector detects a defective area of the insulating layer of the material as a normal area and fails to detect it as a defective area. When the corresponding overlay undetection scenario occurs, the user may recognize that it is a defect scenario due to undetection through the defect checking unit and the apparatus operating unit and may respond to the corresponding undetection defect scenario by adjusting the setting value of the overlay parameter of the second detection adjustment unit.

Similarly, for the insulation coating width abnormality scenario and the overlay width abnormality scenario among the overlay abnormality scenarios may also be handled by adjusting the setting value of the overlay parameter of the second detection adjustment unit.

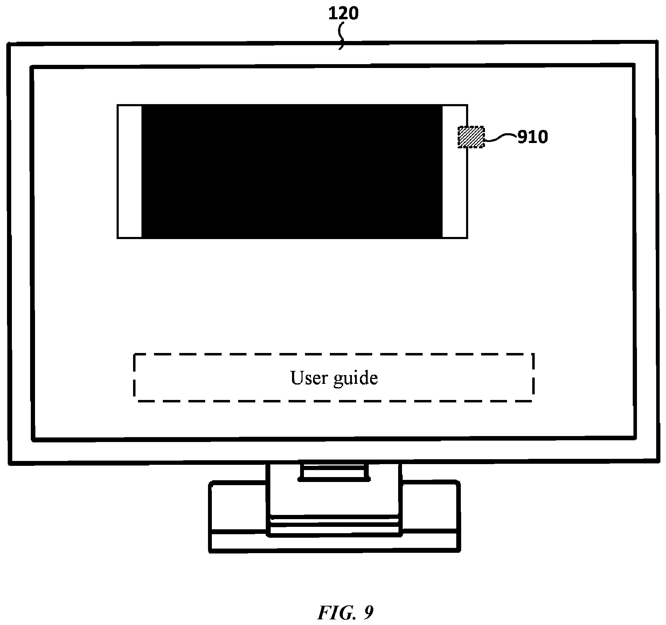

FIG. 9 illustrates an example in which a labeler abnormality scenario has occurred according to an embodiment of the present disclosure. The labeler abnormality scenario may refer to a scenario in which a coating defect occurs in a material, but a label is not issued from a labeler. When a labeler abnormality scenario occurs, an image associated with a label 910 may be displayed on the apparatus operating unit 120, and a guide related to the occurrence of the label abnormality may be output.

When such a labeler abnormality scenario occurs, the user may check model recipe setting information of the defect checking unit 130, and may respond to the labeler abnormality scenario by inputting a labeler number of the model recipe setting based on the work specification or by touching or dragging a specific area of the 3D vision inspector displayed on the apparatus operating unit 120. In other words, the simulation apparatus may receive, from the user, user action information of touching a specific area (work specification selection) to output a work specification; receive, from the user, model recipe setting information of inputting the label number of the defect checking unit; and receive, from the user, user action information of touching a specific area (label input button) of the defect checking unit, thereby allowing the labeler to operate normally.

Then, the simulation apparatus may determine whether the labeler abnormality scenario has been resolved based on the hardware of the corrected vision inspector. For example, when at least one of the user action information or the user condition information is generated based on a touch input or a drag input to a predetermined area in a predetermined order that may be used when resolving the labeler abnormality scenario, or when a predetermined model recipe setting value is input, the simulation apparatus may determine that the labeler abnormality scenario has been resolved. In other words, when the hardware abnormality of the vision inspector is corrected based on at least one of the corresponding user action information or user condition information, the simulation apparatus may determine that the labeler abnormality scenario has been resolved. When it is determined that the defect scenario has been resolved, the apparatus operating unit 120 may indicate that the hardware operates normally.

Similar to the aforementioned labeler abnormality scenario, the lighting abnormality scenario, the camera abnormality scenario, and the encoder abnormality scenario may also be scenarios in which the hardware of the 3D vision inspector malfunctions. When a corresponding hardware abnormality scenario occurs, the user may recognize the hardware malfunction through the defect checking unit and the apparatus operating unit, and may respond to the corresponding hardware abnormality scenario by inputting the model recipe setting value of the defect checking unit, or by touching and dragging the 3D vision inspector of the apparatus operating unit to replace and transfer the position of the abnormal hardware.

An image, a video, and/or an animation indicating part of the 3D vision inspector or the material inspected by the 3D vision inspector may be displayed on the apparatus operating unit 120, but the present disclosure is not limited thereto, and the apparatus operating unit 120 may include images, videos and/or animations of the same shape as the actual package apparatus. With such a configuration, the user may effectively learn in advance how to respond to problems that may occur in the vision inspection process, and the simulation apparatus may effectively determine whether the corresponding training has been completed based on the input or received user actions.

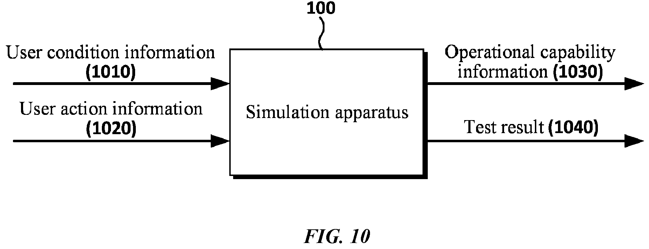

FIG. 10 illustrates an example in which operational capability information 1030 and a test result 1040 are generated according to an embodiment of the present disclosure. As described above, when a training scenario and a defect scenario occur, the simulation apparatus 100 may receive user condition information 1010, user action information 1020 and the like from a user and, based on the received user condition information 1010, user action information 1020 and the like, determine whether the training scenario and the defect scenario has been completed.

According to an embodiment, when it is determined that a training scenario and a defect scenario have been resolved, the simulation apparatus 100 may calculate a progress time and a loss value of the training scenario and the defect scenario while the training scenario and the defect scenario are in progress and, based on the calculated progress time and loss value, generate the operational capability information 1030 for the 3D model apparatus of a user account. In this case, a test result 1040 may be output together with the operational capability information 1030. For example, a user related to the corresponding user account may take a test for arbitrary training scenario and defect scenario, and when all training scenarios and defect scenarios related to a specific 3D model apparatus are resolved according to a predetermined criterion, the simulation apparatus 100 may determine that the corresponding user has passed a simulation test for the specific 3D model apparatus.

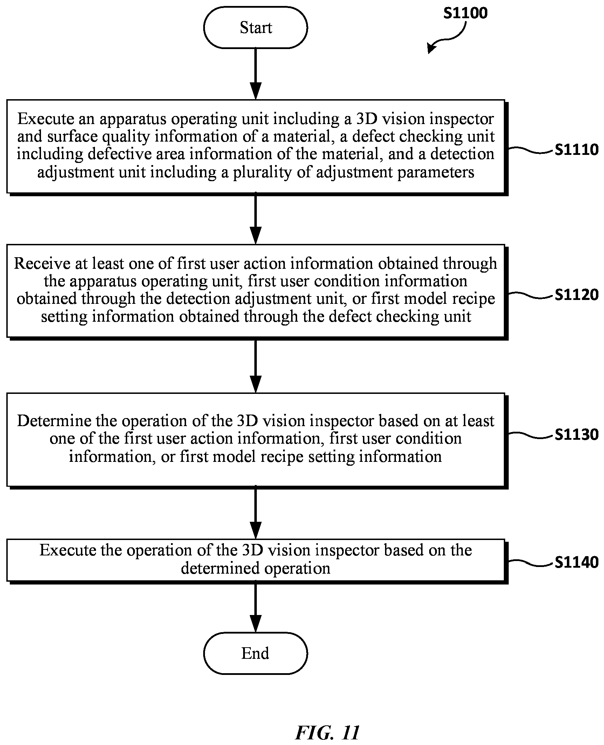

FIG. 11 illustrates an example of a simulation method S1100 of a vision inspector for secondary battery production according to an embodiment of the present disclosure. The simulation method S1100 of a vision inspector for secondary battery production may be performed by a processor (e.g., at least one processor of a simulation apparatus). As illustrated in the figure, the simulation method S1100 of a vision inspector for secondary battery production may be initiated as the processor executes an apparatus operating unit including a 3D vision inspector related to secondary battery production and surface quality information related to surface quality of a material inspected by the 3D vision inspector, and executes a defect checking unit including defective area information of the material detected based on a surface image of the material obtained from the 3D vision inspector, and a detection adjustment unit including a plurality of adjustment parameters for determining an operation of the vision inspector S1110.

The processor may obtain at least one of first user action information obtained through the apparatus operating unit, first user condition information obtained through the detection adjustment unit, or first model recipe setting information obtained through the defect checking unit S1120. In addition, the processor may determine at least one operation of the 3D vision inspector of a vision inspection preparation and a vision inspection adjustment based on at least one of the first user action information, the first model recipe setting information, or the first user condition information obtained S1130. In addition, the processor may execute an operation of inspecting a surface of the material related to the 3D vision inspector based on the determined operation S1140.

According to an embodiment, based on the 3D vision inspector training scenario, the processor may operate the 3D vision inspector in animation, change inspection quality information related to the inspection quality of the 3D vision inspector, output a user action guide for inducing a user action on the apparatus operating unit, or output a user condition guide for inducing a user condition input on the detection adjustment unit. In addition, when receiving the first user action information, the processor may determine whether the received first user action information corresponds to a predetermined operating condition of the 3D vision inspector and approve the operation of the 3D model apparatus when it is determined that the first user action information corresponds to the predetermined operating condition of the 3D vision inspector.

According to an embodiment, the processor may determine one or more training scenarios among a vision inspection preparation training scenario and a vision inspection adjustment training scenario of the 3D vision inspector, and may change at least one of the 3D vision inspector's operation or quality information related to the inspection quality of the 3D vision inspector based on the determined one or more defect scenarios. That is, the processor may determine one or more quality parameters for determining the inspection quality of the 3D vision inspector and, while the operation of the 3D vision inspector is executed, calculate a value corresponding to each of the determined one or more quality parameters based on the operation of the 3D vision inspector in execution, and generate quality information related to the inspection quality of the 3D vision inspector based on the calculated value corresponding to each of the one or more quality parameters.

The vision inspection preparation training may include an inspection specification checking step, a new model registration step, an inspection start step, a detection history inquiry step, and the like, the vision inspection adjustment training may include a surface inspection adjustment training, an overlay adjustment training, and the like, the surface inspection adjustment training may include an image simulation step, a coating portion average brightness adjustment step, a surface defect detection setting step, an uncoated portion-coated portion boundary value setting step, a manual inspection area setting step, a manual mismatch area setting step, and the like, and the overlay adjustment training may include an image simulation step, an overlay defect detection setting step, a camera position adjustment step, a roll cleaning mode step, and the like.

Each training scenario may be completed by at least one of first user condition information, first user action information, or first model recipe setting information input from a user.

According to an embodiment, the processor may determine one or more defect scenarios among a plurality of defect scenarios related to a malfunction of the 3D vision inspector and change at least one of the 3D vision inspector's operation or quality information related to the inspection quality and the surface quality of the material based on the determined one or more defect scenarios. Then, the processor may receive at least one of second user action information, second user condition information or second model recipe setting information for resolving the determined one or more defect scenarios and, based on at least one of the received second user action information, second user condition information, or the second model recipe setting information, may correct the operation of the changed 3D vision inspector. In addition, while the corrected operation of the 3D vision inspector is executed, the processor may calculate a value corresponding to each of a plurality of quality parameters related to the inspection quality of the 3D vision inspector based on the operation of the 3D vision inspector in execution. In this case, the processor may correct the quality information related to the inspection quality of the corrected 3D vision inspector based on the calculated value corresponding to each of the plurality of quality parameters and, by using the corrected quality information, determine whether one or more defect scenarios have been resolved.

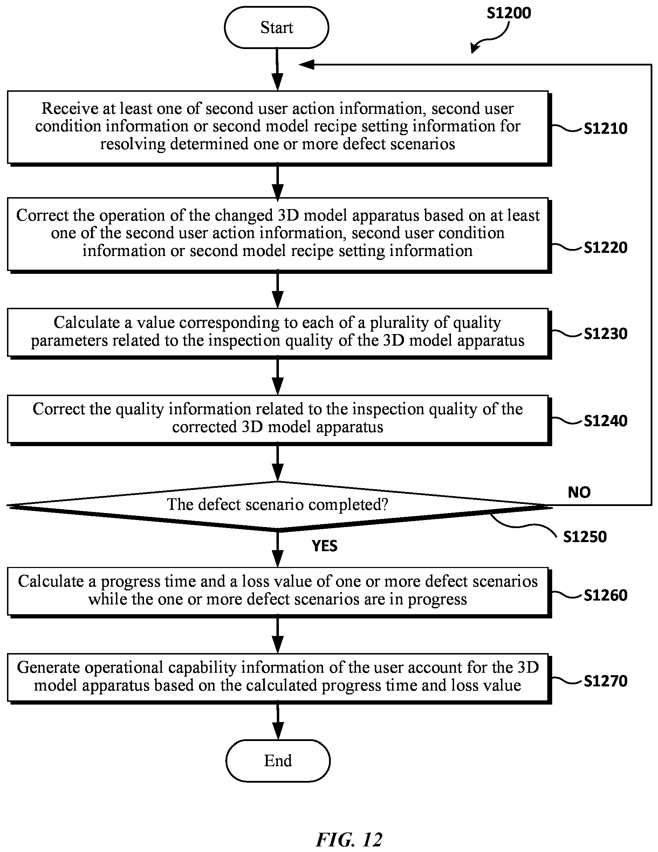

FIG. 12 illustrates an example of a method of calculating a test result S1200 according to an embodiment of the present disclosure. The method of calculating a test result S1200 may be performed by a processor (e.g., at least one processor of a simulation apparatus). As illustrated in the figure, the method of calculating a test result S1200 may be initiated as the processor receives at least one of second user action information, second user condition information or second model recipe setting information for resolving determined one or more defect scenarios S1210.

As described above, the processor may correct the changed operation of the 3D model apparatus based on at least one of the received second user action information, second user condition information, or second model recipe setting information S1220. In addition, while the corrected operation of the 3D model apparatus is executed, the processor may calculate a value corresponding to each of a plurality of quality parameters related to the inspection quality of the 3D model apparatus based on the operation of the 3D model apparatus in execution S1230. In this case, the processor may correct the quality information related to the inspection quality of the corrected 3D model apparatus based on the calculated value corresponding to each of the plurality of quality parameters S1240.

Then, the processor may determine whether one or more defect scenarios have been completed using the corrected inspection quality information and/or the setting values and condition values of the 3D model apparatus S1250. When it is determined that the defect scenario has not been completed, the processor may again generate or obtain the second user action information, the second user condition information and the second model recipe setting information using the information input by the user.

When it is determined that one or more defect scenarios have been completed, the processor may calculate a progress time and a loss value of one or more defect scenarios while one or more defect scenarios are in progress S1260. In addition, based on the calculated progress time and loss value, the processor may generate operational capability information of the user account for the 3D model apparatus S1270. Here, the operational capability information may include, but is not limited to, a progress speed and accuracy calculated using a progress time and a loss value, and may further include the user's test score and whether the user has passed the test. In this case, one user account may be assigned to each user performing secondary battery production; the operational capability information generated based on the user's progress time for a defect scenario and a loss value may be stored or managed in conjunction with the user account.

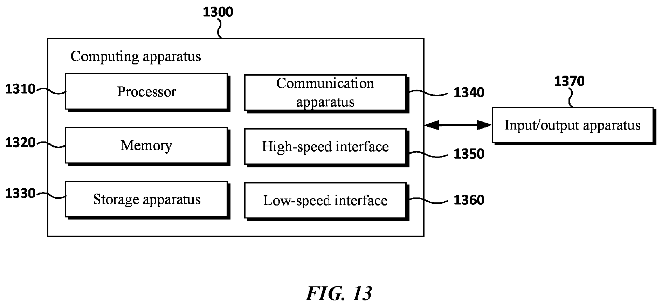

FIG. 13 illustrates an exemplary computing device 1300 for performing the method and/or embodiments. According to an embodiment, the computing device 1300 may be implemented using hardware and/or software configured to interact with a user. Here, the computing device 1300 may include the simulation apparatus (100 of FIG. 1). For example, the computing device 1300 may be configured to support virtual reality (VR), augmented reality (AR), or mixed reality (MR) environments but is not limited thereto. The computing device 1300 may include a laptop computer, a desktop computer, a workstation, a personal digital assistant, a server, a blade server, and a mainframe computer, which is not limited thereto. The constituting elements of the computing device 1300 and connection relationships and functions of the constituting elements are intended to be illustrative and not intended to limit the implementations of the present disclosure described and/or claimed herein.

The computing device 1300 includes a processor 1310, a memory 1320, a storage device 1330, a communication device 1340, a high-speed interface 1350 connected to the memory 1320 and a high-speed expansion port, and a low-speed interface 1360 connected to a low-speed bus and a low-speed storage device. Each of the constituting elements 1310, 1320, 1330, 1340, 1350, 1360 may be interconnected using a variety of buses, mounted on the same main board, or mounted and connected in other suitable ways. The processor 1310 may be configured to process instructions of a computer program by performing basic arithmetic, logic, and input/output operations. For example, the processor 1310 may process instructions stored in the memory 1320 and the storage device 1330 and/or instructions executed within the computing device 1300 and display graphic information on an external input/output device 1370 such as a display device combined with the high-speed interface 1350.

The communication device 1340 may provide a configuration or a function for the input/output device 1370 and the computing device 1300 to communicate with each other through a network and provide a configuration or a function to support the input/output device 1370 and/or the computing device 1300 to communicate with another external apparatus. For example, a request or data generated by the processor of the external apparatus according to an arbitrary program code may be transmitted to the computing device 1300 through a network under the control of the communication device 1340. Conversely, a control signal or a command provided under the control of the processor 1310 of the computing device 1300 may be transmitted to another external device through the communication device 1340 and a network.

FIG. 13 assumes that the computing device 1300 includes one processor 1310 and one memory 1320, but the present disclosure is not limited to the assumption; the computing device 1300 may be implemented using a plurality of memories, a plurality of processors, and/or a plurality of buses. In addition, although FIG. 13 assumes that one computing device 1300 is employed, the present disclosure is not limited to the assumption, and a plurality of computing devices may interact with each other and perform operations required to execute the method described above.

The memory 1320 may store information in the computing device 1300. According to an embodiment, the memory 1320 may include a volatile memory unit or a plurality of memory units. Additionally or alternatively, the memory 1320 may be composed of a non-volatile memory unit or a plurality of memory units. In addition, the memory 1320 may be implemented using a different type of computer-readable medium, such as a magnetic disc or an optical disc. In addition, an operating system and at least one program code and/or instruction may be stored in the memory 1320.

The storage device 1330 may be one or more mass storage devices for storing data for the computing device 1300. For example, the storage device 1330 may be configured to include a hard disc; a magnetic disc such as a portable disc; an optical disc; a semiconductor memory device such as an erasable programmable read-only memory (EPROM), an electrically erasable PROM (EEPROM), and a flash memory; and a computer-readable medium including a CD-ROM or DVD-ROM disc; or the storage device 1330 may be configured to include the computer-readable medium. In addition, the computer program may be implemented tangibly in the computer-readable medium.

The high-speed interface 1350 and the low-speed interface 1360 may be used for interaction with the input/output device 1370. For example, an input device may include a camera including an audio sensor and/or an image sensor, a keyboard, a microphone, and a mouse; an output device may include a display, a speaker, and a haptic feedback device. In another example, the high-speed interface 1350 and the low-speed interface 1360 may be used for interfacing with a device in which a configuration or function for performing input and output operations is integrated into one entity, such as a touch screen.

According to an embodiment, the high-speed interface 1350 manages bandwidth-intensive operations for the computing device 1300, while the low-speed interface 1360 manages less bandwidth-intensive operations than the high-speed interface 1350, where the above functional assignment has been made merely for an illustrative purpose. According to an embodiment, the high-speed interface 1350 may be coupled to high-speed expansion ports capable of accommodating the memory 1320, the input/output device, and various expansion cards (not shown). In addition, the low-speed interface 1360 may be coupled to the storage device 1330 and low-speed expansion ports. Additionally, the low-speed expansion port, which may include various communication ports (e.g., USB, Bluetooth, Ethernet, and wireless Ethernet), may be coupled to one or more input/output devices 1370, such as a keyboard, a pointing device, and a scanner, or a networking device, such as a router or a switch, through a network adaptor.

The computing device 1300 may be implemented in many different forms. For example, the computing device 1300 may be implemented as a standard server or a group of standard servers. Additionally or alternatively, the computing device 1300 may be implemented as part of a rack server system or may be implemented as a personal computer, such as a laptop computer. In this case, constituting elements from the computing device 1300 may be combined with other constituting elements of an arbitrary mobile device (not shown). The computing device 1300 may include one or more other computing devices or may be configured to communicate with one or more computing devices.

FIG. 13 assumes that the input/output device 1370 is not included in the computing device 1300, but the present disclosure is not limited to the assumption; the input/output device 1370 may be configured to be integrated into the computing device 1300 to form a single device. In addition, FIG. 13 illustrates that the high-speed interface 1350 and/or the low-speed interface 1360 are illustrated as being configured separately from the processor 1310; however, the present disclosure is not limited thereto, and the high-speed interface 1350 and/or the low-speed interface 1360 may be configured to be included in the processor 1310.

The method and/or various embodiments described above may be implemented in digital electronic circuitry, computer hardware, firmware, software, and/or a combination thereof. Various embodiments of the present disclosure may be executed by a data processing device, for example, one or more programmable processors and/or one or more computing devices; or implemented as a computer-readable medium and/or a computer program stored on a computer-readable medium. The computer program may be written in any form of programming language including a compiled language or an interpreted language and may be distributed in any form such as a stand-alone program, a module, or a subroutine. The computer program may be distributed via a plurality of computing devices connected through one computing device and the same network and/or a plurality of distributed computing devices connected through a plurality of different networks.

The method and/or various embodiments described above may be performed by one or more processors configured to execute one or more computer programs that process, store, and/or manage arbitrary functions by operating based on input data or generating output data. For example, the method and/or various embodiments of the present disclosure may be performed by a special-purpose logic circuit such as a Field Programmable Gate Array (FPGA) or an Application Specific Integrated Circuit (ASIC); an apparatus and/or a system for performing the method and/or various embodiments of the present disclosure may be implemented as a special-purpose logic circuit such as an FPGA or an ASIC.

The one or more processors executing the computer program may include a general-purpose or special-purpose microprocessor and/or one or more processors of an arbitrary type of digital computing device. The processor may receive instructions and/or data from each of the read-only memory and the random-access memory or may receive instructions and/or data from the read-only memory and the random-access memory. In the present disclosure, the constituting elements of a computing device performing the method and/or embodiments may include one or more processors for executing instructions; and one or more memories for storing instructions and/or data.

According to an embodiment, the computing device may send and receive data to and from one or more mass storage devices for storing data. For example, the computing device may receive data from a magnetic or optical disc and transmit data to the magnetic or optical disc. A computer-readable medium suitable for storing instructions and/or data related to a computer program may include any form of non-volatile memory including a semiconductor memory device such as an Erasable Programmable Read-Only Memory (EPROM), an Electrically Erasable PROM (EEPROM), and a flash memory device; however, the present disclosure is not limited thereto. For example, a computer-readable medium may include a magnetic disc such as an internal hard disc or a removable disc, a photomagnetic disk, a CD-ROM disc, and a DVD-ROM disc.

To provide interaction with a user, the computing device may include a display device (e.g., a cathode ray tube (CRT) or a liquid crystal display (LCD)) for providing or displaying information to the user and a pointing device (e.g., a keyboard, a mouse, or a trackball) through which the user may provide input and/or commands to the computing device by the user; however, the present disclosure is not limited to the specific example above. In other words, the computing device may further include any other kind of device for providing interaction with the user. For example, the computing device may provide any form of sensory feedback to the user for interaction with the user, including visual feedback, auditory feedback, and/or tactile feedback. In response to the feedback, the user may provide input to the computing device through various gestures including a visual expression, voice, and motion.

In the present disclosure, various embodiments may be implemented in a computing device that includes a back-end component (e.g., a data server), a middleware component (e.g., an application server), and/or a front-end component. In this case, the constituting elements may be interconnected by any form or any medium of digital data communication, such as a communication network. According to an embodiment, the communication network includes a wired network such as Ethernet, a wired home network (Power Line Communication), a telephone line communication device, and RS-serial communication; a wireless network such as a mobile communication network, a wireless LAN (WLAN), Wi-Fi, and Bluetooth; or a combination of the wired and wireless networks. For example, the communication network may include a local area network (LAN) and a wide area network (WAN).

A computing device based on the illustrative embodiments described herein may be implemented using hardware and/or software configured to interact with a user, including a user device, a user interface (UI) device, a user terminal, or a client device. For example, the computing device may include a portable computing device such as a laptop computer. Additionally or alternatively, the computing device may include a Personal Digital Assistants (PDA), a tablet PC, a game console, a wearable device, an Internet of Things (IoT) device, a virtual reality (VR) device, and an augmented reality (AR) device but is not limited thereto. The computing device may further include other types of devices configured to interact with the user. In addition, the computing device may include a portable communication device (e.g., a mobile phone, a smartphone, or a wireless cellular phone) suitable for wireless communication over a network, such as a mobile communication network. The computing device may be configured to communicate wirelessly with a network server using wireless communication technologies and/or protocols such as Radio Frequency (RF), Microwave Frequency (MWF), and/or Infrared Ray Frequency (IRF).

Various embodiments of the present disclosure, including specific structural and functional details, are illustrative in nature. Accordingly, the embodiments of the present disclosure are not limited to those described above and may be implemented in various other forms. In addition, the terms used in the present disclosure are intended for describing part of embodiments and should not be construed as limiting the embodiments. For example, singular words and the descriptions above may be construed to include plural forms unless the context dictates otherwise.

Unless defined otherwise, terms used in the present disclosure, including technical or scientific terms, may convey the same meaning understood generally by those skilled in the art to which the present disclosure belongs. Among the terms used in the present disclosure, commonly used terms, such as those defined in ordinary dictionaries, should be interpreted to convey the same meaning in the context of related technology.

## Claims

1. A vision inspector simulation apparatus (100) for secondary battery production, the vision inspector simulation apparatus (100) comprising:
a memory (1320) configured to store at least one instruction; and
at least one processor (1310) configured to execute the at least one instruction stored in the memory (1320) to perform operations comprising:
executing (S1110) a software module apparatus operating unit (120, 210) comprising a virtual 3D vision inspector related to secondary battery production and surface quality information related to surface quality of a material inspected by the virtual 3D vision inspector;
generating a defect scenario having various values related to a malfunction of an actual vision inspector;
executing (S1110) a software module defect checking unit (130) including defective area information of the material detected by the virtual 3D vision inspector;
executing (S1110) a software module detection adjustment unit (140, 150) including a plurality of adjustment parameters for determining an operation of the virtual 3D vision inspector;
obtaining (S1120) at least one of first user action information obtained through the software module apparatus operating unit (120, 210), first user condition information obtained through the software module detection adjustment unit (140, 150), or first model recipe setting information obtained through a software module quality checking unit (450);
determining (S1130) the operation of the virtual 3D vision inspector based on at least one of the first user action information, the first user condition information, or the first model recipe setting information; and
executing (S1140) an operation of inspecting a surface of the material based on the operation of the virtual 3D vision inspector.

2. The apparatus (100) of claim 1, wherein the operations further include:
executing (S1110) a virtual 3D vision inspector training scenario based on an operating process of the virtual 3D vision inspector;
executing (S1110), according to the virtual 3D vision inspector training scenario, at least one of displaying a user action guide on the software module apparatus operating unit (120, 210), displaying a user condition guide on the software module detection adjustment unit (140, 150), or displaying a model recipe setting guide on the software module defect checking unit (130);
obtaining (S1120) at least one of first user action information based on the display of the user action guide, first user condition information based on the display of the user condition guide, or first model recipe setting information based on the display of the model recipe setting guide; and
changing at least one of the software module apparatus operating unit (120, 210), the software module detection adjustment unit (140, 150), or the software module defect checking unit (130) based on at least one of the obtained first user action information, first user condition information, or first model recipe setting information.

3. The apparatus (100) of claim 2, wherein the virtual 3D vision inspector training scenario includes at least one of a vision inspection preparation training scenario (320) or a vision inspection adjustment training scenario (330).

4. The apparatus (100) of claim 3, wherein the vision inspection preparation training scenario (320) includes at least one of an inspection specification checking step, a new model registration step, an inspection start step, or a detection history inquiry step.

5. The apparatus (100) of claim 3 or 4, wherein the vision inspection adjustment training scenario (330) includes at least one of a surface inspection adjustment training or an overlay adjustment training,
wherein the surface inspection adjustment training includes at least one of an image (610) simulation step, a coating portion average brightness adjustment step, a surface defect detection setting step, an uncoated portion-coated portion boundary value setting step, a manual inspection area setting step, or a manual mismatch area setting step, and
wherein the overlay adjustment training includes at least one of an image (610) simulation step, an overlay defect detection setting step, a camera position adjustment step, or a roll cleaning mode step.

6. The apparatus (100) of any one of claims 1 to 5, wherein the operations further include:
determining one or more quality parameters for determining inspection quality of the virtual 3D vision inspector;
calculating a value corresponding to the one or more quality parameters based on the operation of the virtual 3D vision inspector; and
generating quality information related to the inspection quality of the virtual 3D vision inspector based on the calculated value corresponding to the one or more quality parameters.

7. The apparatus (100) of claim 6, wherein the operations further include:
determining a defect scenario (510, 520, 530) among a plurality of defect scenarios (510, 520, 530) related to the operation of the virtual 3D vision inspector; and
changing at least one of the operation of the virtual 3D vision inspector, the inspection quality information related to the inspection quality of the virtual 3D vision inspector, or the surface quality information related to the surface quality of the material based on the one or more defect scenarios (510, 520, 530).

8. The apparatus (100) of claim 7, wherein the defect scenario (510, 520, 530) includes at least one of a surface inspection overdetection scenario, a surface inspection undetection scenario, an overlay abnormality scenario, or a hardware abnormality scenario.

9. The apparatus (100) of claim 8, wherein the operations further include:
executing at least one defect scenario (510, 520, 530) of the surface inspection overdetection scenario, the surface inspection undetection scenario, the overlay abnormality scenario, or the hardware abnormality scenario;
obtaining (S1210) at least one of second user action information of operating at least a partial area of the virtual 3D vision inspector, second user condition information of changing an adjustment parameter of the software module detection adjustment unit (140, 150), or second model recipe setting information of changing a model recipe setting value of the software module quality checking unit (450);
correcting (S1220) the operation of the virtual 3D vision inspector based on at least one of the obtained second user action information, second user condition information, or second model recipe setting information;
calculating (S1230) a value corresponding to the one or more quality parameters related to the inspection quality of the corrected virtual 3D vision inspector; and
correcting (S1240) the inspection quality information related to the inspection quality of the corrected virtual 3D vision inspector based on the calculated value corresponding to the one or more quality parameters.

10. The apparatus (100) of claim 9, wherein the operations further include instructions for outputting guide information including information required to resolve the one or more defect scenarios (510, 520, 530).

11. A vision inspector simulation method (S1100) for secondary battery production, the method being executed by at least one processor, the method comprising:
executing (S1110) a software module apparatus operating unit (120, 210) comprising a virtual 3D vision inspector related to secondary battery production and surface quality information related to surface quality of a material inspected by the virtual 3D vision inspector;
generating a defect scenario having various values related to a malfunction of an actual vision inspector;
executing (S1110) a software module defect checking unit (130) including defective area information of the material detected by the virtual 3D vision inspector;
executing (S1110) a software module detection adjustment unit (140, 150) including a plurality of adjustment parameters for determining an operation of the virtual 3D vision inspector;
obtaining (S1120) at least one of first user action information obtained through the software module apparatus operating unit (120, 210), first user condition information obtained through the software module detection adjustment unit (140, 150), or first model recipe setting information obtained through a software module quality checking unit (450);
determining (S1140) the operation of the virtual 3D vision inspector based on at least one of the first user action information, the first user condition information, or the first model recipe setting information; and
executing (S1150) an operation of inspecting a surface of the material based on the operation of the virtual 3D vision inspector.

12. The method (S1100) of claim 11, further comprising:
executing (S1110) a virtual 3D vision inspector training scenario based on an operating process of the virtual 3D vision inspector;
executing (S1110), according to the virtual 3D vision inspector training scenario, at least one of displaying a user action guide on the software module apparatus operating unit (120, 210), displaying a user condition guide on the software module detection adjustment unit (140, 150), or displaying a model recipe setting guide on the software module defect checking unit (130);
obtaining (S1120) at least one of first user action information based on the display of the user action guide, first user condition information based on the display of the user condition guide, or first model recipe setting information based on the display of the model recipe setting guide; and
changing at least one of the software module apparatus operating unit (120, 210), the software module detection adjustment unit (140, 150), or the software module defect checking unit (130) based on at least one of the obtained first user action information, first user condition information, or first model recipe setting information.

13. The method (S1100) of claim 12, wherein the virtual 3D vision inspector training scenario includes at least one of a vision inspection preparation training scenario or a vision inspection adjustment training scenario.

14. The method (S1100) of any one of claims 11 to 13, further comprising:
determining one or more quality parameters for determining inspection quality of the virtual 3D vision inspector;
calculating (S1230) a value corresponding to the one or more quality parameters based on the operation of the virtual 3D vision inspector; and
generating quality information related to the inspection quality of the virtual 3D vision inspector based on the calculated value corresponding to the one or more quality parameters.

15. The method (S1100) of claim 14, further comprising:
determining a defect scenario (510, 520, 530) among a plurality of defect scenarios (510, 520, 530) related to the operation of the virtual 3D vision inspector; and
changing at least one of the operation of the virtual 3D vision inspector, the inspection quality information related to the inspection quality of the virtual 3D vision inspector, or the surface quality information related to the surface quality of the material based on the one or more defect scenarios (510, 520, 530).

16. A computer program stored in a computer-readable medium provided to execute the method according to any one of claims 11 to 15 on a computer.

## Patentansprüche

1. Sichtinspektor-Simulationsvorrichtung (100) zur Sekundärbatterieproduktion, wobei die Sichtinspektor-Simulationsvorrichtung (100) umfasst:
einen Speicher (1320), der konfiguriert ist zum Speichern mindestens einer Anweisung;
und
mindestens einen Prozessor (1310), der konfiguriert ist zum Ausführen der mindestens einen Anweisung, die in dem Speicher (1320) gespeichert ist, um Betriebsvorgänge durchzuführen, die umfassen:
Ausführen (S1110) einer Softwaremodulvorrichtungs-Betriebseinheit (120, 210) umfassend einen virtuellen 3D-Sichtinspektor in Bezug auf eine Sekundärbatterieproduktion und Oberflächenqualitätsinformationen, die sich auf eine Oberflächenqualität eines Materials beziehen, das durch den virtuellen 3D-Sichtinspektor inspiziert wird;
Erzeugen eines Defektszenarios, das verschiedene Werte aufweist, die sich auf eine Fehlfunktion eines tatsächlichen Sichtinspektors beziehen;
Ausführen (S1110) einer Softwaremodul-Defektprüfeinheit (130), die Defektbereichsinformationen des Materials enthält, das durch den virtuellen 3D-Sichtinspektor detektiert wird;
Ausführen (S1110) einer Softwaremodul-Detektionseinstelleinheit (140, 150), die eine Vielzahl von Einstellparametern zum Bestimmen eines Betriebs des virtuellen 3D-Sichtinspektors enthält;
Erhalten (S1120) von ersten Benutzeraktionsinformationen, die durch die Softwaremodulvorrichtungs-Betriebseinheit (120, 210) erhalten werden, und/oder ersten Benutzerbedingungsinformationen, die durch die Softwaremodul-Detektionseinstelleinheit (140, 150) erhalten werden, und/oder ersten Modellrezeptsetzinformationen, die durch die Qualitätsprüfeinheit (450) erhalten werden;
Bestimmen (S1130) des Betriebs des virtuellen 3D-Sichtinspektors basierend auf den ersten Benutzeraktionsinformationen und/oder den ersten Benutzerbedingungsinformationen und/oder den ersten Modellrezeptsetzinformationen; und
Ausführen (S1140) eines Betriebs eines Inspizierens einer Oberfläche des Materials basierend auf dem Betrieb des virtuellen 3D-Sichtinspektors.

2. Vorrichtung (100) nach Anspruch 1, wobei die Betriebsvorgänge ferner umfassen:
Ausführen (S1110) eines virtuellen 3D-Sichtinspektor-Trainingsszenarios basierend auf einem Betriebsprozess des virtuellen 3D-Sichtinspektors;
Ausführen (S1110), gemäß dem virtuellen 3D-Sichtinspektor-Trainingsszenario, eines Anzeigens einer Benutzeraktionsanleitung auf der Softwaremodulvorrichtungs-Betriebseinheit (120, 210) und/oder eines Anzeigens einer Benutzerbedingungsanleitung auf der Softwaremodul-Detektionseinstelleinheit (140, 150) und/oder eines Anzeigens einer Modellrezeptsetzanleitung auf der Softwaremodul-Defektprüfeinheit (130);
Erhalten (S1120) von ersten Benutzeraktionsinformationen basierend auf der Anzeige der Benutzeraktionsanleitung und/oder ersten Benutzerbedingungsinformationen basierend auf der Anzeige der Benutzerbedingungsanleitung und/oder ersten Modellrezeptsetzinformationen basierend auf der Anzeige der Modellrezeptsetzanleitung; und
Ändern der Softwaremodulvorrichtungs-Betriebseinheit (120, 210) und/oder der Softwaremodul-Detektionseinstelleinheit (140, 150) und/oder der Softwaremodul-Defektprüfeinheit (130) basierend auf den erhaltenen ersten Benutzeraktionsinformationen und/oder ersten Benutzerbedingungsinformationen und/oder ersten Modellrezeptsetzinformationen.

3. Vorrichtung (100) nach Anspruch 2, wobei das virtuelle 3D-Sichtinspektor-Trainingsszenario ein Sichtinspektions-Vorbereitungstrainingsszenario (320) und/oder ein Sichtinspektions-Einstelltrainingsszenario (330) enthält.

4. Vorrichtung (100) nach Anspruch 3, wobei das Sichtinspektions-Vorbereitungstrainingsszenario (320) einen Inspektionsspezifikationsprüfschritt und/oder einen Neumodellregistrierungsschritt und/oder einen Inspektionsstartschritt und/oder einen Detektionsverlaufsabfrageschritt enthält.

5. Vorrichtung (100) nach Anspruch 3 oder 4, wobei das Sichtinspektions-Einstelltrainingsszenario (330) ein Oberflächeninspektions-Einstelltraining und/oder ein Überlagerungseinstelltraining enthält,
wobei das Oberflächeninspektions-Einstelltraining einen Bildsimulationsschritt (610) und/oder einen Beschichtungsabschnitt-Durchschnittshelligkeitseinstellschritt und/oder einen Oberflächendefekt-Detektionseinstellschritt und/oder einen Nicht-Beschichtungsabschnitt-Beschichtungsabschnitt-Grenzwerteinstellschritt und/oder einen manuellen Inspektionsbereichseinstellschritt und/oder einen manuellen Nichtübereinstimmungsbereichseinstellschritt enthält, und
wobei das Überlagerungseinstelltraining einen Bildsimulationsschritt (610) und/oder einen Überlagerungsdefekt-Detektionseinstellschritt und/oder einen Kamerapositionseinstellschritt und/oder einen Walzenreinigungsmodusschritt enthält.

6. Vorrichtung (100) nach einem der Ansprüche 1 bis 5, wobei die Betriebsvorgänge ferner umfassen:
Bestimmen eines oder mehrerer Qualitätsparameter zum Bestimmen einer Inspektionsqualität des virtuellen 3D-Sichtinspektors;
Berechnen eines Werts, der dem einen oder den mehreren Qualitätsparametern entspricht, basierend auf dem Betrieb des virtuellen 3D-Sichtinspektors; und
Erzeugen von Qualitätsinformationen, die sich auf die Inspektionsqualität des virtuellen 3D-Sichtinspektors beziehen, basierend auf dem berechneten Wert, der dem einen oder den mehreren Qualitätsparametern entspricht.

7. Vorrichtung (100) nach Anspruch 6, wobei die Betriebsvorgänge ferner umfassen:
Bestimmen eines Defektszenarios (510, 520, 530) unter einer Vielzahl von Defektszenarien (510, 520, 530), die sich auf den Betrieb des virtuellen 3D-Sichtinspektors beziehen; und
Ändern des Betriebs des virtuellen 3D-Sichtinspektors und/oder der Inspektionsqualitätsinformationen, die sich auf die Inspektionsqualität des virtuellen 3D-Sichtinspektors beziehen, und/oder der Oberflächenqualitätsinformationen, die sich auf die Oberflächenqualität des Materials beziehen, basierend auf dem einen oder den mehreren Defektszenarien (510, 520, 530).

8. Vorrichtung (100) nach Anspruch 7, wobei das Defektszenario (510, 520, 530) ein Oberflächeninspektions-Überdetektionsszenario und/oder ein Oberflächeninspektions-Nichtdetektionsszenario und/oder ein Überlagerungsanomalieszenario und/oder ein Hardwareanomalieszenario enthält.

9. Vorrichtung (100) nach Anspruch 8, wobei die Betriebsvorgänge ferner umfassen:
Ausführen mindestens eines Defektszenarios (510, 520, 530) des Oberflächeninspektions-Überdetektionsszenarios, des Oberflächeninspektions-Nichtdetektionsszenarios, des Überlagerungsanomalieszenarios und/oder des Hardwareanomalieszenarios;
Erhalten (S1210) von zweiten Benutzeraktionsinformationen zum Betreiben mindestens eines Teilbereichs des virtuellen 3D-Sichtinspektors und/oder zweiten Benutzerbedingungsinformationen zum Ändern eines Einstellparameters der Softwaremodul-Detektionseinstelleinheit (140, 150) und/oder zweiten Modellrezeptsetzinformationen zum Ändern eines Modellrezeptsetzwerts der Qualitätsprüfeinheit (450);
Korrigieren (S1220) des Betriebs des virtuellen 3D-Sichtinspektors basierend auf den erhaltenen zweiten Benutzeraktionsinformationen und/oder zweiten Benutzerbedingungsinformationen und/oder zweiten Modellrezeptsetzinformationen;
Berechnen (S1230) eines Werts, der dem einen oder den mehreren Qualitätsparametern entspricht, die sich auf die Inspektionsqualität des korrigierten virtuellen 3D-Sichtinspektors beziehen; und
Korrigieren (S1240) der Inspektionsqualitätsinformationen, die sich auf die Inspektionsqualität des korrigierten virtuellen 3D-Sichtinspektors beziehen, basierend auf dem berechneten Wert, der dem einen oder den mehreren Qualitätsparametern entspricht.

10. Vorrichtung (100) nach Anspruch 9, wobei die Betriebsvorgänge ferner Anweisungen zum Ausgeben von Anleitungsinformationen enthalten, die Informationen enthalten, die erforderlich sind, um das eine oder die mehreren Defektszenarien (510, 520, 530) aufzulösen.

11. Sichtinspektor-Simulationsverfahren (S1100) zur Sekundärbatterieproduktion, wobei das Verfahren durch mindestens einen Prozessor ausgeführt wird, wobei das Verfahren umfasst:
Ausführen (S1110) einer Softwaremodulvorrichtungs-Betriebseinheit (120, 210) umfassend einen virtuellen 3D-Sichtinspektor in Bezug auf eine Sekundärbatterieproduktion und Oberflächenqualitätsinformationen, die sich auf eine Oberflächenqualität eines Materials beziehen, das durch den virtuellen 3D-Sichtinspektor inspiziert wird;
Erzeugen eines Defektszenarios, das verschiedene Werte aufweist, die sich auf eine Fehlfunktion eines tatsächlichen Sichtinspektors beziehen;
Ausführen (S1110) einer Softwaremodul-Defektprüfeinheit (130), die Defektbereichsinformationen des Materials enthält, das durch den virtuellen 3D-Sichtinspektor detektiert wird;
Ausführen (S1110) einer Softwaremodul-Detektionseinstelleinheit (140, 150), die eine Vielzahl von Einstellparametern zum Bestimmen eines Betriebs des virtuellen 3D-Sichtinspektors enthält;
Erhalten (S1120) von ersten Benutzeraktionsinformationen, die durch die Softwaremodulvorrichtungs-Betriebseinheit (120, 210) erhalten werden, und/oder ersten Benutzerbedingungsinformationen, die durch die Softwaremodul-Detektionseinstelleinheit (140, 150) erhalten werden, und/oder ersten Modellrezeptsetzinformationen, die durch die Qualitätsprüfeinheit (450) erhalten werden;
Bestimmen (S1140) des Betriebs des virtuellen 3D-Sichtinspektors basierend auf den ersten Benutzeraktionsinformationen und/oder den ersten Benutzerbedingungsinformationen und/oder den ersten Modellrezeptsetzinformationen; und
Ausführen (S1150) eines Betriebs eines Inspizierens einer Oberfläche des Materials basierend auf dem Betrieb des virtuellen 3D-Sichtinspektors.

12. Verfahren (S1100) nach Anspruch 11, ferner umfassend:
Ausführen (S1110) eines virtuellen 3D-Sichtinspektor-Trainingsszenarios basierend auf einem Betriebsprozess des virtuellen 3D-Sichtinspektors;
Ausführen (S1110), gemäß dem virtuellen 3D-Sichtinspektor-Trainingsszenario, eines Anzeigens einer Benutzeraktionsanleitung auf der Softwaremodulvorrichtungs-Betriebseinheit (120, 210) und/oder eines Anzeigens einer Benutzerbedingungsanleitung auf der Softwaremodul-Detektionseinstelleinheit (140, 150) und/oder eines Anzeigens einer Modellrezeptsetzanleitung auf der Softwaremodul-Defektprüfeinheit (130);
Erhalten (S1120) von ersten Benutzeraktionsinformationen basierend auf der Anzeige der Benutzeraktionsanleitung und/oder ersten Benutzerbedingungsinformationen basierend auf der Anzeige der Benutzerbedingungsanleitung und/oder ersten Modellrezeptsetzinformationen basierend auf der Anzeige der Modellrezeptsetzanleitung; und
Ändern der Softwaremodulvorrichtungs-Betriebseinheit (120, 210) und/oder der Softwaremodul-Detektionseinstelleinheit (140, 150) und/oder der Softwaremodul-Defektprüfeinheit (130) basierend auf den erhaltenen ersten Benutzeraktionsinformationen und/oder ersten Benutzerbedingungsinformationen und/oder ersten Modellrezeptsetzinformationen.

13. Verfahren (S1100) nach Anspruch 12, wobei das virtuelle 3D-Sichtinspektor-Trainingsszenario ein Sichtinspektions-Vorbereitungstrainingsszenario und/oder ein Sichtinspektions-Einstelltrainingsszenario enthält.

14. Verfahren (S1100) nach einem der Ansprüche 11 bis 13, ferner umfassend:
Bestimmen eines oder mehrerer Qualitätsparameter zum Bestimmen einer Inspektionsqualität des virtuellen 3D-Sichtinspektors;
Berechnen (S1230) eines Werts, der dem einen oder den mehreren Qualitätsparametern entspricht, basierend auf dem Betrieb des virtuellen 3D-Sichtinspektors; und
Erzeugen von Qualitätsinformationen, die sich auf die Inspektionsqualität des virtuellen 3D-Sichtinspektors beziehen, basierend auf dem berechneten Wert, der dem einen oder den mehreren Qualitätsparametern entspricht.

15. Verfahren (S1100) nach Anspruch 14, ferner umfassend:
Bestimmen eines Defektszenarios (510, 520, 530) unter einer Vielzahl von Defektszenarien (510, 520, 530), die sich auf den Betrieb des virtuellen 3D-Sichtinspektors beziehen; und
Ändern des Betriebs des virtuellen 3D-Sichtinspektors und/oder der Inspektionsqualitätsinformationen, die sich auf die Inspektionsqualität des virtuellen 3D-Sichtinspektors beziehen, und/oder der Oberflächenqualitätsinformationen, die sich auf die Oberflächenqualität des Materials beziehen, basierend auf dem einen oder den mehreren Defektszenarien (510, 520, 530).

16. Computerprogramm, das in einem computerlesbaren Medium gespeichert ist, das zum Ausführen des Verfahrens nach einem der Ansprüche 11 bis 15 auf einem Computer bereitgestellt ist.

## Revendications

1. Dispositif de simulation d'inspecteur visuel (100) pour la production de batteries secondaires, ledit dispositif de simulation d'inspecteur visuel (100) comprenant :
une mémoire (1320) configurée pour stocker au moins une instruction ; et
au moins un processeur (1310) configuré pour exécuter ladite au moins une instruction stockée en mémoire (1320) afin d'effectuer des opérations comprenant :
l'exécution (S1110) d'une unité d'exploitation de dispositif à module logiciel (120, 210) comprenant un inspecteur visuel 3D virtuel associé à la production de batteries secondaires et des informations de qualité de surface d'un matériel inspecté par l'inspecteur visuel 3D virtuel ;
la génération d'un scénario de défaut ayant différentes valeurs relatives à un dysfonctionnement d'un inspecteur visuel effectif ;
l'exécution (S1110) d'une unité de contrôle de défaut à module logiciel (130) comprenant des informations de zone défectueuse du matériel détectée par l'inspecteur visuel 3D virtuel ;
l'exécution (S1110) d'une unité de réglage de détection à module logiciel (140, 150) comprenant une pluralité de paramètres de réglage pour déterminer une opération de l'inspecteur visuel 3D virtuel ;
l'obtention (S1120) de premières informations d'action d'utilisateur obtenues par l'unité d'exploitation de dispositif à module logiciel (120, 210), et/ou de premières informations d'état d'utilisateur obtenues par l'unité de réglage de détection à module logiciel (140, 150), et/ou de premières informations d'établissement de schéma de modèle obtenues par une unité de contrôle de qualité à module logiciel (450) ;
la détermination (S1130) de l'opération de l'inspecteur visuel 3D virtuel sur la base des premières informations d'action d'utilisateur, et/ou des premières informations d'état d'utilisateur et/ou des premières informations d'établissement de schéma de modèle ; et l'exécution (S1140) d'une opération d'inspection d'une surface du matériel sur la base de l'opération de l'inspecteur visuel 3D virtuel.

2. Dispositif (100) selon la revendication 1, où les opérations comprennent en outre :
l'exécution (S1110) d'un scénario d'apprentissage d'inspecteur visuel 3D virtuel sur la base d'un processus d'actionnement de l'inspecteur visuel 3D virtuel ;
l'exécution (S1110), conformément au scénario d'apprentissage d'inspecteur visuel 3D virtuel, d'un affichage d'un guide d'action d'utilisateur sur l'unité d'exploitation de dispositif à module logiciel (120, 210), et/ou d'un affichage d'un guide d'état d'utilisateur sur l'unité de réglage de détection à module logiciel (140, 150), et/ou d'un affichage d'un guide d'établissement de schéma de modèle sur l'unité de contrôle de défaut à module logiciel (130) ;
l'obtention (S1120) de premières informations d'action d'utilisateur sur la base de l'affichage du guide d'action d'utilisateur, et/ou de premières informations d'état d'utilisateur sur la base de l'affichage du guide d'état d'utilisateur, et/ou de premières informations d'établissement de schéma de modèle sur la base de l'affichage du guide d'établissement de schéma de modèle ; et
la modification de l'unité d'exploitation de dispositif à module logiciel (120, 210), et/ou de l'unité de réglage de détection à module logiciel (140, 150), et/ou de l'unité de contrôle de défaut à module logiciel (130) sur la base des premières informations d'action d'utilisateur obtenues, et/ou des premières informations d'état d'utilisateur, et/ou des premières informations d'établissement de schéma de modèle obtenues.

3. Dispositif (100) selon la revendication 2, où le scénario d'apprentissage d'inspecteur visuel 3D virtuel comprend un scénario d'apprentissage de préparation à une inspection visuelle (320) et/ou un scénario d'apprentissage de réglage d'inspection visuelle (330).

4. Dispositif (100) selon la revendication 3, où le scénario d'apprentissage de préparation à une inspection visuelle (320) comprend une étape de contrôle des spécifications d'inspection, et/ou une étape d'enregistrement d'un nouveau schéma, et/ou une étape de début d'inspection, et/ou une étape d'enquête sur l'historique de détection.

5. Dispositif (100) selon la revendication 3 ou la revendication 4, où le scénario d'apprentissage de réglage d'inspection visuelle (330) comprend un apprentissage au réglage d'inspection de surface et/ou un apprentissage au réglage de revêtement,
où l'apprentissage au réglage d'inspection de surface comprend une étape de simulation d'image (610), et/ou une étape de réglage de luminosité moyenne de partie de revêtement, et/ou une étape de réglage de détection de défaut de surface, et/ou une étape de réglage de valeur de limite entre partie non revêtue-partie revêtue, et/ou une étape de réglage de zone d'inspection manuelle, et/ou une étape de réglage de zone de non-correspondance manuelle, et
où l'apprentissage de réglage de revêtement comprend une étape de simulation d'image (610), et/ou une étape de réglage de détection de défaut de revêtement, et/ou une étape de réglage de position de caméra, et/ou une étape de mode de nettoyage de rouleau.

6. Dispositif (100) selon l'une des revendications 1 à 5, où les opérations comprennent en outre :
la détermination d'un ou de plusieurs paramètres de qualité pour déterminer une qualité d'inspection de l'inspecteur visuel 3D virtuel ;
le calcul d'une valeur correspondant au paramètre, ou aux plusieurs paramètres de qualité sur la base du fonctionnement de l'inspecteur visuel 3D virtuel ; et
la génération d'informations de qualité relatives à la qualité d'inspection de l'inspecteur visuel 3D virtuel sur la base de la valeur calculée correspondant au paramètre, ou aux plusieurs paramètres de qualité.

7. Dispositif (100) selon la revendication 6, où les opérations comprennent en outre :
la détermination d'un scénario de défaut (510, 520, 530) parmi une pluralité de scénarios de défaut (510, 520, 530) relatifs au fonctionnement de l'inspecteur visuel 3D virtuel ; et
la modification de l'opération de l'inspecteur visuel 3D virtuel, et/ou des informations de qualité d'inspection relatives à la qualité d'inspection de l'inspecteur visuel 3D virtuel, et/ou des informations de qualité de surface relatives à la qualité de surface du matériel sur la base du ou des scénarios de défaut (510, 520, 530).

8. Dispositif (100) selon la revendication 7, où le scénario de défaut (510, 520, 530) comprend un scénario de surdétection d'inspection de surface, et/ou un scénario de non-détection d'inspection de surface, et/ou un scénario d'anomalie de revêtement, et/ou un scénario d'anomalie matérielle.

9. Dispositif (100) selon la revendication 8, où les opérations comprennent en outre :
l'exécution d'un scénario de défaut (510, 520, 530) du scénario de surdétection d'inspection de surface, et/ou du scénario de non-détection d'inspection de surface, et/ou du scénario d'anomalie de revêtement et/ou du scénario d'anomalie matérielle ;
l'obtention (S1210) de deuxièmes informations d'action d'utilisateur actionnant au moins une zone partielle de l'inspecteur visuel 3D virtuel, et/ou de deuxièmes informations d'état d'utilisateur modifiant un paramètre de réglage de l'unité de réglage de détection à module logiciel (140, 150), et/ou de deuxièmes informations d'établissement de schéma de modèle modifiant une valeur de réglage de schéma de modèle de l'unité de contrôle de qualité à module logiciel (450) ;
la correction (S1220) de l'opération de l'inspecteur visuel 3D virtuel sur la base des deuxièmes informations d'action d'utilisateur, et/ou des deuxièmes informations d'état d'utilisateur et/ou des deuxièmes informations d'établissement de schéma de modèle obtenues ;
le calcul (S1230) d'une valeur correspondant au paramètre, ou aux plusieurs paramètres de qualité relatifs à la qualité d'inspection de l'inspecteur visuel 3D virtuel corrigé ; et
la correction (S1240) des informations de qualité d'inspection relatives à la qualité d'inspection de l'inspecteur visuel 3D virtuel corrigé sur la base de la valeur calculée correspondant au paramètre, ou aux plusieurs paramètres de qualité.

10. Dispositif (100) selon la revendication 9, où les opérations comprennent en outre des instructions pour l'émission d'informations de guide comprenant des informations requises pour résoudre le ou les scénarios de défaut (510, 520, 530).

11. Procédé de simulation d'inspecteur visuel (S1100) pour la production de batteries secondaires, ledit procédé étant exécuté par au moins un processeur, ledit procédé comprenant :
l'exécution (S1110) d'une unité d'exploitation de dispositif à module logiciel (120, 210) comprenant un inspecteur visuel 3D virtuel associé à la production de batteries secondaires et des informations de qualité de surface d'un matériel inspecté par l'inspecteur visuel 3D virtuel ;
la génération d'un scénario de défaut ayant différentes valeurs relatives à un dysfonctionnement d'un inspecteur visuel effectif ;
l'exécution (S1110) d'une unité de contrôle de défaut à module logiciel (130) comprenant des informations de zone défectueuse du matériel détectée par l'inspecteur visuel 3D virtuel ;
l'exécution (S1110) d'une unité de réglage de détection à module logiciel (140, 150) comprenant une pluralité de paramètres de réglage pour déterminer une opération de l'inspecteur visuel 3D virtuel ;
l'obtention (S1120) de premières informations d'action d'utilisateur obtenues par l'unité d'exploitation de dispositif à module logiciel (120, 210), et/ou de premières informations d'état d'utilisateur obtenues par l'unité de réglage de détection à module logiciel (140, 150), et/ou de premières informations d'établissement de schéma de modèle obtenues par une unité de contrôle de qualité à module logiciel (450) ;
la détermination (S1140) de l'opération de l'inspecteur visuel 3D virtuel sur la base des premières informations d'action d'utilisateur, et/ou des premières informations d'état d'utilisateur et/ou des premières informations d'établissement de schéma de modèle ; et l'exécution (S1150) d'une opération d'inspection d'une surface du matériel sur la base de l'opération de l'inspecteur visuel 3D virtuel.

12. Procédé (S1100) selon la revendication 11, comprenant en outre :
l'exécution (S1110) d'un scénario d'apprentissage d'inspecteur visuel 3D virtuel sur la base d'un processus d'actionnement de l'inspecteur visuel 3D virtuel ;
l'exécution (S1110), conformément au scénario d'apprentissage d'inspecteur visuel 3D virtuel, d'un affichage d'un guide d'action d'utilisateur sur l'unité d'exploitation de dispositif à module logiciel (120, 210), et/ou d'un affichage d'un guide d'état d'utilisateur sur l'unité de réglage de détection à module logiciel (140, 150), et/ou d'un affichage d'un guide d'établissement de schéma de modèle sur l'unité de contrôle de défaut à module logiciel (130) ;
l'obtention (S1120) de premières informations d'action d'utilisateur sur la base de l'affichage du guide d'action d'utilisateur, et/ou de premières informations d'état d'utilisateur sur la base de l'affichage du guide d'état d'utilisateur, et/ou de premières informations d'établissement de schéma de modèle sur la base de l'affichage du guide d'établissement de schéma de modèle ; et
la modification de l'unité d'exploitation de dispositif à module logiciel (120, 210), et/ou de l'unité de réglage de détection à module logiciel (140, 150), et/ou de l'unité de contrôle de défaut à module logiciel (130) sur la base des premières informations d'action d'utilisateur obtenues, et/ou des premières informations d'état d'utilisateur, et/ou des premières informations d'établissement de schéma de modèle obtenues.

13. Procédé (S1100) selon la revendication 12, où le scénario d'apprentissage d'inspecteur visuel 3D virtuel comprend un scénario d'apprentissage de préparation à une inspection visuelle et/ou un scénario d'apprentissage de réglage d'inspection visuelle.

14. Procédé (S1100) selon l'une des revendications 11 à 13, comprenant en outre :
la détermination d'un ou de plusieurs paramètres de qualité pour déterminer une qualité d'inspection de l'inspecteur visuel 3D virtuel ;
le calcul (S1230) d'une valeur correspondant au paramètre, ou aux plusieurs paramètres de qualité sur la base du fonctionnement de l'inspecteur visuel 3D virtuel ; et
la génération d'informations de qualité relatives à la qualité d'inspection de l'inspecteur visuel 3D virtuel sur la base de la valeur calculée correspondant au paramètre, ou aux plusieurs paramètres de qualité.

15. Procédé (S1100) selon la revendication 14, comprenant en outre :
la détermination d'un scénario de défaut (510, 520, 530) parmi une pluralité de scénarios de défaut (510, 520, 530) relatifs au fonctionnement de l'inspecteur visuel 3D virtuel ; et
la modification de l'opération de l'inspecteur visuel 3D virtuel, et/ou des informations de qualité d'inspection relatives à la qualité d'inspection de l'inspecteur visuel 3D virtuel, et/ou des informations de qualité de surface relatives à la qualité de surface du matériel sur la base du ou des scénarios de défaut (510, 520, 530).

16. Programme informatique enregistré sur un support lisible par ordinateur, prévu pour exécuter le procédé selon l'une des revendications 11 à 15 sur un ordinateur.
